# EUROPEAN PATENT SPECIFICATION

(11) **EP 4 106 034 B1**
(45) Date of publication and mention of the grant of the patent: **08.01.2025**
(21) Application number: 21180258.2
(22) Date of filing: 18.06.2021
(51) Int. Cl.: H10K 85/30, H10K 50/15, H10K 50/155, H10K 50/17, H10K 71/16

(54) **ORGANIC ELECTRONIC DEVICE COMPRISING A METAL COMPOUND COMPRISING METAL CATION AND AT LEAST ONE BORATE ANION OF FORMULA (I), DISPLAY DEVICE COMPRISING THE ORGANIC ELECTRONIC DEVICE, USE OF THE METAL COMPOUND IN AN ORGANIC ELECTRONIC DEVICE, AND METHOD FOR PREPARATION OF THE ORGANIC ELECTRONIC DEVICE**
ORGANISCHE ELEKTRONISCHE VORRICHTUNG MIT EINER METALLVERBINDUNG MIT EINEM METALLKATION UND MINDESTENS EINEM BORATANION DER FORMEL (I), ANZEIGEVORRICHTUNG MIT DER ORGANISCHEN ELEKTRONISCHEN VORRICHTUNG, VERWENDUNG DER METALLVERBINDUNG IN EINER ORGANISCHEN ELEKTRONISCHEN VORRICHTUNG UND VERFAHREN ZUR HERSTELLUNG DER ORGANISCHEN ELEKTRONISCHEN VORRICHTUNG
DISPOSITIF ÉLECTRONIQUE ORGANIQUE COMPRENANT UN COMPOSÉ MÉTALLIQUE COMPORTANT DES CATIONS MÉTALLIQUES ET AU MOINS UN ANION DE BORATE DE FORMULE (I), DISPOSITIF D'AFFICHAGE COMPRENANT LE DISPOSITIF ÉLECTRONIQUE ORGANIQUE, UTILISATION DU COMPOSÉ MÉTALLIQUE DANS UN DISPOSITIF ÉLECTRONIQUE ORGANIQUE ET PROCÉDÉ DE PRÉPARATION DU DISPOSITIF ÉLECTRONIQUE ORGANIQUE

(43) Date of publication of application: 21.12.2022
(73) Proprietor: Novaled GmbH, 01099 Dresden (DE)
(72) Inventor: HUMMERT, Markus, 01099 Dresden (DE); UVAROV, Vladimir, 01099 Dresden (DE)
(74) Representative: Michalski Hüttermann & Partner Patentanwälte mbB

(56) References cited:
- EP-A1- 3 364 475
- WO-A1-2013/079676
- US-A1- 2011 278 559

## Description

### Technical Field

The present invention relates to an organic electronic device comprising a metal compound comprising metal cation and at least one borate anion of formula (I), a display device comprising the organic electronic device, a use of the metal compound in an organic electronic device, and a method for preparation of the organic electronic device.

### Background Art

Organic electronic devices, such as organic light-emitting diodes OLEDs, which are selfemitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

US 2011/0278559 A1 describes compositions comprising reaction products of a conjugated polymer, and at least one dopant.

EP 3 364 475 A1 discloses an electronic device comprising between a first electrode and a second electrode at least one first semiconducting layer comprising (i) at least one first hole transport matrix compound consisting of covalently bound atoms and (ii) at least one electrical p-dopant selected from metal borate complexes, wherein the metal borate complex consists of at least one metal cation and at least one anionic ligand consisting of at least six covalently bound atoms which comprises at least one boron atom, wherein the first semiconducting layer is a hole injection layer, a hole-injecting part of a charge generating layer or a hole transport layer, a method for preparing the same and a compound which may be comprised therein.

Performance of an organic light emitting diode may be affected by characteristics of the semiconductor layer, and among them, may be affected by characteristics of metal complexes which are also contained in the semiconductor layer.

There remains a need to improve performance of organic semiconductor materials, semiconductor layers, as well as organic electronic devices thereof, in particular to achieve improved operating voltage stability over time, improved operating voltage, improved current efficiency, and improved lifetime, through improving the characteristics of the compounds comprised therein.

### DISCLOSURE

An aspect of the present invention provides an organic electronic device comprising an anode layer, a cathode layer, at least one semiconductor layer, and at least one photoactive layer, wherein the at least one photoactive layer is arranged between the anode layer and the cathode layer, and wherein the at least one semiconductor layer is arranged between the anode layer and the at least one photoactive layer,
wherein the at least one semiconductor layer comprises a metal compound comprising a metal cation and at least one borate anion of formula (I) 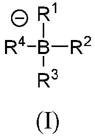
wherein R¹, R², R³, and R⁴ are independently selected from H, electron-withdrawing group, halogen, Cl, F, CN, substituted or unsubstituted C₁ to C₂₄ alkyl, substituted or unsubstituted C₃ to C₂₄ carbocyclyl, substituted or unsubstituted C₂ to C₂₄ heterocyclyl, substituted or unsubstituted C₆ to C₂₄ aryl, or substituted or unsubstituted C₂ to C₂₄ heteroaryl, and two of R¹, R², R³, and R⁴ together can form a ring with the boron atom;
wherein the substituents on R¹, R², R³, and R⁴, if present, are independently selected from electron-withdrawing group, halogen, Cl, F, CN, NO₂, partially fluorinated or perfluorinated alkoxy, partially fluorinated or perfluorinated alkyl, partially fluorinated or perfluorinated aryl, partially fluorinated or perfluorinated heteroaryl, partially fluorinated or perfluorinated carbocyclyl, and partially fluorinated or perfluorinated heterocyclyl;
and wherein at least one R¹, R², R³, and R⁴ is attached to the boron atom via a carbon atom.

It should be noted that throughout the application and the claims any Rⁿ etc. always refer to the same moieties, unless otherwise noted.

In the present specification, when a definition is not otherwise provided, "partially fluorinated" refers to a hydrocarbon group in which only part of the hydrogen atoms are replaced by fluorine atoms.

In the present specification, when a definition is not otherwise provided, "perfluorinated" refers to a hydrocarbon group in which all hydrogen atoms are replaced by fluorine atoms.

In the present specification, when a definition is not otherwise provided, an "alkyl group" refers to a saturated aliphatic hydrocarbyl group. The alkyl group may be a C₁ to C₂₄ alkyl group. More specifically, the alkyl group may be a C₁ to C₁₀ alkyl group or a C₁ to C₆ alkyl group. For example, a C₁ to C₄ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an isopropyl group, a butyl group, an iso-butyl group, a sec-butyl group, a tert-butyl group, a pentyl group, a hexyl group.

The term "cycloalkyl" or "carbocyclyl" are used synonymously and refer to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphtyl or fluoren-2-yl.

Analogously, under heteroaryl, it is especially where suitable understood a group derived by formal abstraction of one ring hydrogen from a heterocyclic aromatic ring in a compound comprising at least one such ring.

Under heterocycloalkyl or heterocyclyl, which are used synonymously, it is especially understood a carbocyclyl group wherein a ring carbon atom is replaced by another polyvalent atom. Preferably, the heteroatoms are selected from B, Si, N, P, O, S; more preferably from N, P, O, S.

The term "electron-withdrawing group" refers to a chemical group in a molecule, which can draw electrons away from an adjacent part of the molecule. The distance over which the electron-withdrawing group can exert its effect, namely the number of bonds over which the electron-withdrawing effect spans, is extended by conjugated pi-electron systems such as aromatic systems. Examples of electron-withdrawing groups include NO₂, CN, halogen, Cl, F, partially fluorinated or perfluorinated alkyl and partially fluorinated or perfluorinated C₁ to C₁₂ alkyl, partially fluorinated or perfluorinated alkoxy, partially fluorinated or perfluorinated C₁ to C₆ alkoxy.

The term "fused aryl rings" or "condensed aryl rings" is understood the way that two aryl rings are considered fused or condensed when they share at least two common sp²-hybridized carbon atoms

In the present specification, the single bond refers to a direct bond.

The term "free of", "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms "anode", "anode layer" and "anode electrode" are used synonymously.

The terms "cathode", "cathode layer" and "cathode electrode" are used synonymously.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

### Advantageous Effects

Surprisingly, it was found that the organic compound of the present invention solves the problem underlying the present invention by enabling devices in various aspects superior over the organic electroluminescent devices known in the art, in particular with respect to operating voltage stability over time, improved operating voltage, improved current efficiency, and improved lifetime.

According to one embodiment of the present invention, at least two of R¹, R², R³, and R⁴ are attached to the boron atom via a carbon atom, preferably at least three, more preferably all four.

According to one embodiment of the present invention, the at least one, the at least two, the at least three or the all four R¹, R², R³, and R⁴ attached to the boron atom via a carbon atom are selected independently from substituted or unsubstituted C₁ to C₂₄ alkyl, substituted or unsubstituted C₃ to C₂₄ carbocyclyl, substituted or unsubstituted C₂ to C₂₄ heterocyclyl, substituted or unsubstituted C₆ to C₂₄ aryl, or substituted or unsubstituted C₂ to C₂₄ heteroaryl.

According to one embodiment of the present invention, at least one of R¹, R², R³, and R⁴, preferably at least two, more preferably at least three, most preferably all four, are independently selected from Cl, F, CN, substituted or unsubstituted C₁ to C₂₄ alkyl, substituted or unsubstituted C₃ to C₂₄ carbocyclyl, substituted or unsubstituted C₂ to C₂₄ heterocyclyl, substituted or unsubstituted C₆ to C₂₄ aryl, or substituted or unsubstituted C₂ to C₂₄ heteroaryl;
preferably from substituted or unsubstituted C₁ to C₂₄ alkyl, substituted or unsubstituted C₃ to C₂₄ carbocyclyl, substituted or unsubstituted C₂ to C₂₄ heterocyclyl, substituted or unsubstituted C₆ to C₂₄ aryl, or substituted or unsubstituted C₂ to C₂₄ heteroaryl;
more preferably from substituted or unsubstituted C₁ to C₂₄ alkyl, substituted or unsubstituted C₃ to C₂₄ carbocyclyl, substituted or unsubstituted C₆ to C₂₄ aryl, or substituted or unsubstituted C₂ to C₂₄ heteroaryl;
more preferably from substituted or unsubstituted C₁ to C₂₄ alkyl, substituted or unsubstituted C₃ to C₂₄ carbocyclyl, or substituted or unsubstituted C₆ to C₂₄ aryl;
more preferably from substituted or unsubstituted C₁ to C₂₄ alkyl, or substituted or unsubstituted C₃ to C₂₄ carbocyclyl;
more preferably from substituted or unsubstituted C₁ to C₂₄ alkyl;
more preferably from substituted or unsubstituted C₁ to C₄ alkyl.

According to one embodiment of the present invention, for the case that R¹, R², R³, and/or R⁴ is alkyl, carbocyclyl, heterocyclyl, aryl, or heteroaryl, the respective alkyl, carbocyclyl, heterocyclyl, aryl, or heteroaryl is substituted.

According to one embodiment of the present invention, for the case that R¹, R², R³, and/or R⁴ is substituted, the respective R¹, R², R³, and/or R⁴ is partially or fully substituted.

According to one embodiment of the present invention, for the case that R¹, R², R³, and/or R⁴ is alkyl, the respective alkyl is a substituted or unsubstituted C₁ to C₂₂ alkyl, preferably a substituted or unsubstituted C₁ to C₂₀ alkyl, more preferably a substituted or unsubstituted C₁ to C_{1g} alkyl, more preferably a substituted or unsubstituted C₁ to C₁₆ alkyl, more preferably a substituted or unsubstituted C₁ to C₁₄ alkyl, more preferably a substituted or unsubstituted C₁ to C₁₂ alkyl C₁ to C₁₀ alkyl, more preferably a substituted or unsubstituted C₁ to C₈ alkyl, more preferably a substituted or unsubstituted C₁ to C₆ alkyl, more preferably a substituted or unsubstituted C₁ to C₄ alkyl, more preferably a substituted or unsubstituted C₁ to C₃ alkyl, more preferably a substituted or unsubstituted C₁ to C₂ alkyl, and more preferably a substituted or unsubstituted C₁ alkyl.

According to one embodiment of the present invention, for the case that R¹, R², R³, and/or R⁴ is carbocyclyl, the respective carbocyclyl is a substituted or unsubstituted C₃ to C₂₀ carbocyclyl, preferably a substituted or unsubstituted C₃ to C₁₆ carbocyclyl, more preferably a substituted or unsubstituted C₃ to C₁₄ carbocyclyl, more preferably a substituted or unsubstituted C₃ to C₁₂ carbocyclyl, more preferably a substituted or unsubstituted C₃ to C₁₀ carbocyclyl, more preferably a substituted or unsubstituted C₃ to C₈ carbocyclyl, more preferably a substituted or unsubstituted C₃ to C₆ carbocyclyl.

According to one embodiment of the present invention, for the case that R¹, R², R³, and/or R⁴ is heterocyclyl, the respective heterocyclyl is a substituted or unsubstituted C₂ to C₂₀ heterocyclyl, preferably a substituted or unsubstituted C₂ to C₁₆ heterocyclyl, more preferably a substituted or unsubstituted C₂ to C₁₄ heterocyclyl, more preferably a substituted or unsubstituted C₂ to C₁₂ heterocyclyl, more preferably a substituted or unsubstituted C₂ to C₁₀ heterocyclyl, more preferably a substituted or unsubstituted C₂ to C₉ heterocyclyl, more preferably a substituted or unsubstituted C₂ to C₅ heterocyclyl

According to one embodiment of the present invention, for the case that R¹, R², R³, and/or R⁴ is heteroaryl, the respective heteroaryl is a substituted or unsubstituted C₂ to C₂₀ heteroaryl, preferably a substituted or unsubstituted C₂ to C₁₆ heteroaryl, more preferably a substituted or unsubstituted C₂ to C₁₄ heteroaryl, more preferably a substituted or unsubstituted C₂ to C₁₂ heteroaryl, more preferably a substituted or unsubstituted C₂ to C₁₀ heteroaryl, more preferably a substituted or unsubstituted C₂ to C₉ heteroaryl, more preferably a substituted or unsubstituted C₂ to C₅ heteroaryl. According to one embodiment of the present invention, for the case that R¹, R², R³, and/or R⁴ is heteroaryl, the respective heteroaryl is bonded to the boron atom via a carbon bond.

According to one embodiment of the present invention, for the case that R¹, R², R³, and/or R⁴ is aryl, the respective aryl is a substituted or unsubstituted C₆ to C₂₀ aryl, preferably a substituted or unsubstituted C₆ to C₁₆ aryl, more preferably a substituted or unsubstituted C₆ to C₁₄ aryl, more preferably a substituted or unsubstituted C₆ to C₁₂ aryl, more preferably a substituted or unsubstituted C₆ to C₁₀ aryl.

According to one embodiment of the present invention, the substituents on R¹, R², R³, and/or R⁴ are independently selected from Cl, F, CN, NO₂, partially fluorinated or perfluorinated C₁ to C₂₄ alkoxy, partially fluorinated or perfluorinated C₁ to C₂₄ alkyl, partially fluorinated or perfluorinated C₆ to C₂₄ aryl, partially fluorinated or perfluorinated C₂ to C₂₄ heteroaryl, partially fluorinated or perfluorinated C₃ to C₂₄ carbocyclyl, and partially fluorinated or perfluorinated C₂ to C₂₄ heterocyclyl.

According to one embodiment of the present invention, for the case that the substituents on R¹, R², R³, and/or R⁴ is partially fluorinated or perfluorinated alkoxy, the partially fluorinated or perfluorinated alkoxy is a C₁ to C₂₂ alkoxy, preferably a C₁ to C₂₀ alkoxy, more preferably a C₁ to C₁₈ alkoxy, more preferably a C₁ to C₁₆ alkoxy, more preferably a C₁ to C₁₄ alkoxy, more preferably a C₁ to C₁₂ alkoxy, more preferably a C₁ to C₁₀ alkoxy, more preferably a C₁ to C₈ alkoxy, more preferably a C₁ to C₆ alkoxy, more preferably a C₁ to C₄ alkoxy, more preferably a C₁ to C₃ alkoxy, more preferably a C₁ to C₂ alkoxy, more preferably a C₁ alkoxy.

According to one embodiment of the present invention, for the case that the substituents on R¹, R², R³, and/or R⁴ is partially fluorinated or perfluorinated alkyl, the partially fluorinated or perfluorinated alkyl is a C₁ to C₂₂ alkyl, preferably a C₁ to C₂₀ alkyl, more preferably a C₁ to C₁₈ alkyl, more preferably a C₁ to C₁₆ alkyl, more preferably a C₁ to C₁₄ alkyl, more preferably a C₁ to C₁₂ alkyl, more preferably a C₁ to C₁₀ alkyl, more preferably a C₁ to C₈ alkyl, more preferably a C₁ to C₆ alkyl, more preferably a C₁ to C₄ alkyl, more preferably a C₁ to C₃ alkyl, more preferably a C₁ to C₂ alkyl, more preferably a C₁ alkyl.

According to one embodiment of the present invention, for the case that the substituents on R¹, R², R³, and/or R⁴ is partially fluorinated or perfluorinated aryl, the partially fluorinated or perfluorinated aryl is a C₆ to C₂₀ aryl, preferably a C₆ to C₁₆ aryl, more preferably a C₆ to C₁₄ aryl, more preferably a C₆ to C₁₂ aryl, more preferably a C₆ to C₁₀ aryl.

According to one embodiment of the present invention, for the case that the substituents on R¹, R², R³, and/or R⁴ is partially fluorinated or perfluorinated heteroaryl, the partially fluorinated or perfluorinated heteroaryl is a C₂ to C₂₀ heteroaryl, preferably a C₂ to C₁₆ heteroaryl, more preferably a C₂ to C₁₄ heteroaryl, more preferably a C₂ to C₁₂ heteroaryl, more preferably C₂ to C₁₀ heteroaryl, more preferably a C₂ to C₉ heteroaryl, more preferably a C₂ to C₅ heteroaryl.

According to one embodiment of the present invention, for the case that the substituents on R¹, R², R³, and/or R⁴ is partially fluorinated or perfluorinated carbocyclyl, the partially fluorinated or perfluorinated carbocyclyl is a C₃ to C₂₀ carbocyclyl, preferably a C₃ to C₁₆ carbocyclyl, more preferably a C₃ to C₁₄ carbocyclyl, more preferably a C₃ to C₁₂ carbocyclyl, more preferably a C₃ to C₁₀ carbocyclyl, more preferably a C₃ to C₈ carbocyclyl, more preferably a C₃ to C₆ carbocyclyl.

According to one embodiment of the present invention, for the case that the substituents on R¹, R², R³, and/or R⁴ is partially fluorinated or perfluorinated heterocyclyl, the partially fluorinated or perfluorinated heterocyclyl is a C₂ to C₂₀ heterocyclyl, preferably a C₂ to C₁₆ heterocyclyl, more preferably a C₂ to C₁₄ heterocyclyl, more preferably a C₂ to C₁₂ heterocyclyl, more preferably a C₂ to C₁₀ heterocyclyl, more preferably a C₂ to C₉ heterocyclyl, more preferably a C₂ to C₅ heterocyclyl.

According to one embodiment of the present invention, the substituents on R¹, R², R³, and/or R⁴ are independently selected from Cl, CN, F, CF₃, C₂F₅, n- *n*-C₃F₇, and *iso*-C₃F₇, preferably F, CF₃, C₂F₅, *n*-C₃F₇, and *iso*-C₃F₇, more preferably Cl, F, and CN, wherein the substituents are most preferably F.

According to one embodiment of the present invention, R¹, R², R³, and R⁴ are independently selected from H, halogen, Cl, F, CN, partially or fully halogenated C₁ to C₂₄ alkyl, partially or fully halogenated C₃ to C₂₄ carbocyclyl, partially or fully halogenated C₂ to C₂₄ heterocyclyl, partially or fully halogenated C₆ to C₂₄ aryl, or partially or fully halogenated C₂ to C₂₄ heteroaryl, and two of R¹, R², R³, and R⁴ together can form a ring with the boron atom.

According to one embodiment of the present invention, R¹, R², R³, and R⁴ are independently selected from Cl, F, CN, partially or fully halogenated C₁ to C₂₄ alkyl, partially or fully halogenated C₃ to C₂₄ carbocyclyl, partially or fully halogenated C₂ to C₂₄ heterocyclyl, partially or fully halogenated C₆ to C₂₄ aryl, or partially or fully halogenated C₂ to C₂₄ heteroaryl and two of R¹, R², R³, and R⁴ together can form a ring with the boron atom.

According to one embodiment of the present invention, R¹, R², R³, and R⁴ are independently selected from partially or fully halogenated C₁ to C₂₄ alkyl, partially or fully halogenated C₃ to C₂₄ carbocyclyl, partially or fully halogenated C₂ to C₂₄ heterocyclyl, partially or fully halogenated C₆ to C₂₄ aryl, or partially or fully halogenated C₂ to C₂₄ heteroaryl and two of R¹, R², R³, and R⁴ together can form a ring with the boron atom.

According to one embodiment of the present invention, R¹, R², R³, and R⁴ are independently selected from H, halogen, Cl, F, CN, partially fluorinated or perfluorinated C₁ to C₂₄ alkyl, partially fluorinated or perfluorinated C₃ to C₂₄ carbocyclyl, partially fluorinated or perfluorinated C₂ to C₂₄ heterocyclyl, partially fluorinated or perfluorinated C₆ to C₂₄ aryl, or partially fluorinated or perfluorinated C₂ to C₂₄ heteroaryl and two of R¹, R², R³, and R⁴ together can form a ring with the boron atom.

According to one embodiment of the present invention, R¹, R², R³, and R⁴ are independently selected from Cl, F, CN, partially fluorinated or perfluorinated C₁ to C₂₄ alkyl, partially fluorinated or perfluorinated C₃ to C₂₄ carbocyclyl, partially fluorinated or perfluorinated C₂ to C₂₄ heterocyclyl, partially fluorinated or perfluorinated C₆ to C₂₄ aryl, or partially fluorinated or perfluorinated C₂ to C₂₄ heteroaryl and two of R¹, R², R³, and R⁴ together can form a ring with the boron atom.

According to one embodiment of the present invention, R¹, R², R³, and R⁴ are independently selected from partially fluorinated or perfluorinated C₁ to C₂₄ alkyl, partially fluorinated or perfluorinated C₃ to C₂₄ carbocyclyl, partially fluorinated or perfluorinated C₂ to C₂₄ heterocyclyl, partially fluorinated or perfluorinated C₆ to C₂₄ aryl, or partially fluorinated or perfluorinated C₂ to C₂₄ heteroaryl and two of R¹, R², R³, and R⁴ together can form a ring with the boron atom.

According to one embodiment of the present invention, the at least one, the at least two, the at least three or the all four R¹, R², R³, and R⁴ attached to the boron atom via a carbon atom is selected independently from partially or fully halogenated C₁ to C₂₄ alkyl, partially or fully halogenated C₃ to C₂₄ carbocyclyl, partially or fully halogenated C₂ to C₂₄ heterocyclyl, partially or fully halogenated C₆ to C₂₄ aryl, or partially or fully halogenated C₂ to C₂₄ heteroaryl, and two of R¹, R², R³, and R⁴ together can form a ring with the boron atom.

According to one embodiment of the present invention, the at least one, the at least two, the at least three or the all four R¹, R², R³, and R⁴ attached to the boron atom via a carbon atom is selected independently from partially fluorinated or perfluorinated C₁ to C₂₄ alkyl, partially fluorinated or perfluorinated C₃ to C₂₄ carbocyclyl, partially fluorinated or perfluorinated C₂ to C₂₄ heterocyclyl, partially fluorinated or perfluorinated C₆ to C₂₄ aryl, or partially fluorinated or perfluorinated C₂ to C₂₄ heteroaryl.

According to one embodiment of the present invention, at least one of R¹, R², R³, and R⁴, preferably at least two, more preferably at least three, most preferably all four, are independently selected from F, Cl , CN, CF₃, C₂F₅, *n*-C₃F₇, and *iso*-C₃F₇.

According to one embodiment of the present invention, at least two, preferably at least three, more preferably all four, of R¹, R², R³, and R⁴ are the same.

According to one embodiment of the present invention, the total number of carbon atoms in the borate anion of formula (I) is ≤ 45, preferably ≤ 40, more preferably ≤35.

According to one embodiment of the present invention, the borate anion is selected from one of the following structures:

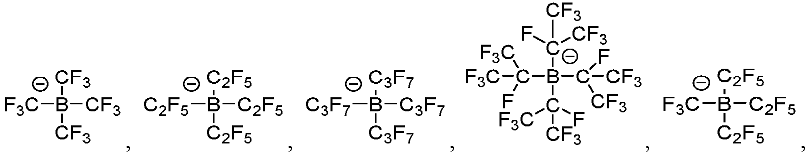

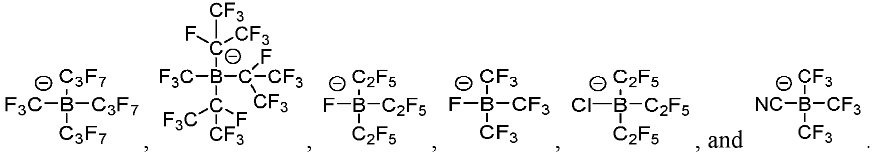

According to one embodiment of the present invention, the metal compound is selected from formula (II): 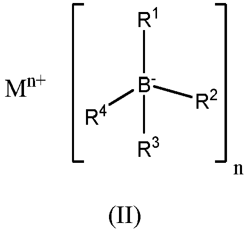 wherein M is a metal cation and n is the valence of the metal cation.

According to one embodiment of the present invention, M is selected from alkali metals, alkaline earth metals, rare earth metals, transition metals, Al, Ga, In, Tl, Sn, Pb, Bi or mixtures thereof and n is 1, 2 or 3, wherein preferably M is selected from Li, Na, K, Rb, Cs, Cu, Ag or mixtures thereof and n is 1, or M is selected from Be, Mg, Ca, Sr, Ba, Mn, Fe, Co, Ni, Cu, Zn, Cd or mixtures thereof and n is 2, wherein more preferably M is selected from Na, K, Cs Cu, Ag or mixtures thereof and n is 1, or M is selected from Mg, Ca, Mn, Co, Zn, Cu or mixtures thereof and n is 2, wherein most preferably M is K or Cs and n is 1, or M is Co and n is 2.

According to one embodiment of the present invention, M is selected from Na, K, Cs, and Ag, preferably from K, Cs, and Ag, most preferably from K and Cs.

According to one embodiment of the present invention, the metal compound is selected from the following structures: 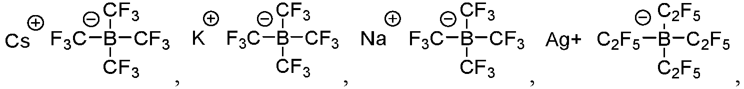 and

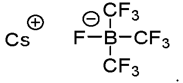

According to one embodiment of the present invention, the semiconductor layer is a hole injection layer or hole transport layer, preferably a hole injection layer.

According to one embodiment of the present invention, the semiconductor layer is adjacent to the anode layer, preferably in direct contact with the anode layer.

According to one embodiment of the present invention, the semiconductor layer further comprises a matrix compound.

According to one embodiment of the present invention, the matrix is non-polymeric. According to one embodiment of the present invention, the semiconductor layer comprises a matrix material in particular a substantially covalent matrix material.

### Further embodiments

According to one embodiment of the present invention, there is provided an organic electronic device comprising an anode layer, a cathode layer, at least one semiconductor layer, and at least one photoactive layer, wherein the at least one photoactive layer is arranged between the anode layer and the cathode layer, and wherein the at least one semiconductor layer is arranged between the anode layer and the at least one photoactive layer,
wherein the at least one semiconductor layer comprises a metal compound comprising a metal cation and at least one borate anion of formula (I) 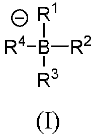
wherein R¹, R², R³, and R⁴ are independently selected from H, electron-withdrawing group, halogen, Cl, F, CN, substituted or unsubstituted C₁ to C₂₄ alkyl, substituted or unsubstituted C₃ to C₂₄ carbocyclyl, substituted or unsubstituted C₂ to C₂₄ heterocyclyl, substituted or unsubstituted C₆ to C₂₄ aryl, or substituted or unsubstituted C₂ to C₂₄ heteroaryl, and two of R¹, R², R³, and R⁴ together can form a ring with the boron atom;
wherein the substituents on R¹, R², R³, and R⁴, if present, are independently selected from electron-withdrawing group, halogen, Cl, F, CN, NO₂, partially fluorinated or perfluorinated alkoxy, partially fluorinated or perfluorinated alkyl, partially fluorinated or perfluorinated aryl, partially fluorinated or perfluorinated heteroaryl, partially fluorinated or perfluorinated carbocyclyl, and partially fluorinated or perfluorinated heterocyclyl;
and wherein at least one R¹, R², R³, and R⁴ is attached to the boron atom via a carbon atom.

According to one embodiment of the present invention, there is provided an organic electronic device comprising an anode layer, a cathode layer, at least one semiconductor layer, and at least one photoactive layer, wherein the at least one photoactive layer is arranged between the anode layer and the cathode layer, and wherein the at least one semiconductor layer is arranged between the anode layer and the at least one photoactive layer,
wherein the at least one semiconductor layer comprises a metal compound comprising a metal cation and at least one borate anion of formula (I) 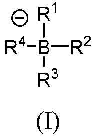
wherein R¹, R², R³, and R⁴ are independently selected from H, halogen, Cl, F, CN, substituted C₁ to C₂₄ alkyl, substituted C₃ to C₂₄ carbocyclyl, substituted C₂ to C₂₄ heterocyclyl, substituted C₆ to C₂₄ aryl, or substituted C₂ to C₂₄ heteroaryl, and two of R¹, R², R³, and R⁴ together can form a ring with the boron atom;
wherein the substituents on R¹, R², R³, and R⁴, are independently selected from halogen,
and wherein at least one R¹, R², R³, and R⁴ is attached to the boron atom via a carbon atom.

According to one embodiment of the present invention, there is provided an organic electronic device comprising an anode layer, a cathode layer, at least one semiconductor layer, and at least one photoactive layer, wherein the at least one photoactive layer is arranged between the anode layer and the cathode layer, and wherein the at least one semiconductor layer is arranged between the anode layer and the at least one photoactive layer,
wherein the at least one semiconductor layer comprises a metal compound comprising a metal cation and at least one borate anion of formula (I) 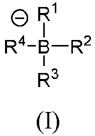
wherein R¹, R², R³, and R⁴ are independently selected from Cl, F, CN, substituted C₁ to C₂₄ alkyl, substituted C₃ to C₂₄ carbocyclyl, substituted C₂ to C₂₄ heterocyclyl, substituted C₆ to C₂₄ aryl, or substituted C₂ to C₂₄ heteroaryl, and two of R¹, R², R³, and R⁴ together can form a ring with the boron atom;
wherein the substituents on R¹, R², R³, and R⁴, are independently selected from halogen,
and wherein at least one R¹, R², R³, and R⁴ is attached to the boron atom via a carbon atom.

According to one embodiment of the present invention, there is provided an organic electronic device comprising an anode layer, a cathode layer, at least one semiconductor layer, and at least one photoactive layer, wherein the at least one photoactive layer is arranged between the anode layer and the cathode layer, and wherein the at least one semiconductor layer is arranged between the anode layer and the at least one photoactive layer,
wherein the at least one semiconductor layer comprises a metal compound comprising a metal cation and at least one borate anion of formula (I) 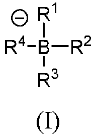
wherein R¹, R², R³, and R⁴ are independently selected from substituted C₁ to C₂₄ alkyl, substituted C₃ to C₂₄ carbocyclyl, substituted C₂ to C₂₄ heterocyclyl, substituted C₆ to C₂₄ aryl, or substituted C₂ to C₂₄ heteroaryl, and two of R¹, R², R³, and R⁴ together can form a ring with the boron atom;
wherein the substituents on R¹, R², R³, and R⁴, are independently selected from halogen,
and wherein at least one R¹, R², R³, and R⁴ is attached to the boron atom via a carbon atom.

According to one embodiment of the present invention, there is provided an organic electronic device comprising an anode layer, a cathode layer, at least one semiconductor layer, and at least one photoactive layer, wherein the at least one photoactive layer is arranged between the anode layer and the cathode layer, and wherein the at least one semiconductor layer is arranged between the anode layer and the at least one photoactive layer,
wherein the at least one semiconductor layer comprises a metal compound comprising a metal cation and at least one borate anion of formula (I) 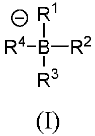
R¹, R², R³, and R⁴ are independently selected from H, halogen, Cl, F, CN, partially or fully halogenated C₁ to C₂₄ alkyl, partially or fully halogenated C₃ to C₂₄ carbocyclyl, partially or fully halogenated C₂ to C₂₄ heterocyclyl, partially or fully halogenated and/or partially or fully haloalkylated C₆ to C₂₄ aryl, or partially or fully halogenated C₂ to C₂₄ heteroaryl and two of R¹, R², R³, and R⁴ together can form a ring with the boron atom,
and wherein at least one R¹, R², R³, and R⁴ is attached to the boron atom via a carbon atom.
wherein the at least one R¹, R², R³, and R⁴ attached to the boron atom via a carbon atom is independently selected from fully halogenated C₁ to C₂₄ alkyl, partially or fully halogenated C₃ to C₂₄ carbocyclyl, partially or fully halogenated C₂ to C₂₄ heterocyclyl, partially or fully halogenated C₆ to C₂₄ aryl, or partially or fully halogenated C₂ to C₂₄ heteroaryl.

According to one embodiment of the present invention, there is provided an organic electronic device comprising an anode layer, a cathode layer, at least one semiconductor layer, and at least one photoactive layer, wherein the at least one photoactive layer is arranged between the anode layer and the cathode layer, and wherein the at least one semiconductor layer is arranged between the anode layer and the at least one photoactive layer,
wherein the at least one semiconductor layer comprises a metal compound comprising a metal cation and at least one borate anion of formula (I) 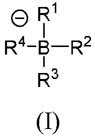
R¹, R², R³, and R⁴ are independently selected from H, halogen, Cl, F, CN, partially fluorinated or perfluorinated C₁ to C₂₄ alkyl, partially fluorinated or perfluorinated C₃ to C₂₄ carbocyclyl, partially fluorinated or perfluorinated C₂ to C₂₄ heterocyclyl, partially fluorinated or perfluorinated C₆ to C₂₄ aryl, or partially fluorinated or perfluorinated C₂ to C₂₄ heteroaryl, and two of R¹, R², R³, and R⁴ together can form a ring with the boron atom,
and wherein at least one R¹, R², R³, and R⁴ is attached to the boron atom via a carbon atom,
wherein the at least one R¹, R², R³, and R⁴ attached to the boron atom via a carbon atom is independently selected from partially fluorinated or perfluorinated C₁ to C₂₄ alkyl, partially fluorinated or perfluorinated C₃ to C₂₄ carbocyclyl, partially fluorinated or perfluorinated C₂ to C₂₄ heterocyclyl, partially fluorinated or perfluorinated and/or partially or fully fluoroalkylated C₆ to C₂₄ aryl, or partially fluorinated or perfluorinated C₂ to C₂₄ heteroaryl.

### Substantially covalent matrix compound

The organic semiconductor layer may further comprises a substantially covalent matrix compound. According to one embodiment the substantially covalent matrix compound may be selected from at least one organic compound. The substantially covalent matrix may consists substantially from covalently bound C, H, O, N, S, which optionally comprise in addition covalently bound B, P, As and/or Se.

According to one embodiment of the organic electronic device, the organic semiconductor layer further comprises a substantially covalent matrix compound, wherein the substantially covalent matrix compound may be selected from organic compounds consisting substantially from covalently bound C, H, O, N, S, which optionally comprise in addition covalently bound B, P, As and/or Se.

Organometallic compounds comprising covalent bonds carbon-metal, metal complexes comprising organic ligands and metal salts of organic acids are further examples of organic compounds that may serve as substantially covalent matrix compounds of the hole injection layer.

In one embodiment, the substantially covalent matrix compound lacks metal atoms and majority of its skeletal atoms may be selected from C, O, S, N. Alternatively, the substantially covalent matrix compound lacks metal atoms and majority of its skeletal atoms may be selected from C and N.

According to one embodiment, the substantially covalent matrix compound may have a molecular weight Mw of > 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

Preferably, the substantially covalent matrix compound comprises at least one arylamine moiety, alternatively a diarylamine moiety, alternatively a triarylamine moiety.

Preferably, the substantially covalent matrix compound is free of metals and/or ionic bonds.

### Compound of formula (VI) or a compound of formula (VII)

According to another aspect of the present invention, the at least one matrix compound, also referred to as "substantially covalent matrix compound", may comprises at least one arylamine compound, diarylamine compound, triarylamine compound, a compound of formula (VI) or a compound of formula (VII) 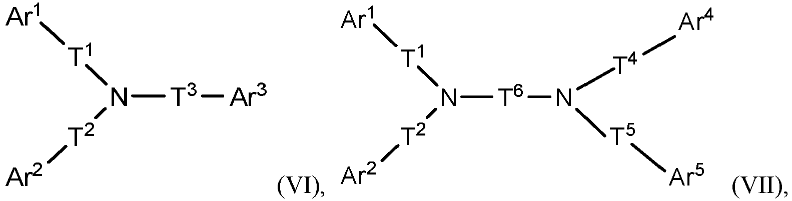 wherein:
T¹, T², T³, T⁴ and T⁵ are independently selected from a single bond, phenylene, biphenylene, terphenylene or naphthenylene, preferably a single bond or phenylene;
T⁶ is phenylene, biphenylene, terphenylene or naphthenylene;
Ar¹, Ar², Ar³, Ar⁴ and Ar⁵ are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein
the substituents of Ar¹, Ar², Ar³, Ar⁴ and Ar⁵ are selected the same or different from the group comprising H, D, F, C(=O)R², CN, Si(R²)₃, P(=O)(R²)₂, OR², S(=O)R², S(=O)₂R², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl.

According to an embodiment wherein T¹, T², T³, T⁴ and T⁵ may be independently selected from a single bond, phenylene, biphenylene or terphenylene. According to an embodiment wherein T¹, T², T³, T⁴ and T⁵ may be independently selected from phenylene, biphenylene or terphenylene and one of T¹, T², T³, T⁴ and T⁵ are a single bond. According to an embodiment wherein T¹, T², T³, T⁴ and T⁵ may be independently selected from phenylene or biphenylene and one of T¹, T², T³, T⁴ and T⁵ are a single bond. According to an embodiment wherein T¹, T², T³, T⁴ and T⁵ may be independently selected from phenylene or biphenylene and two of T¹, T², T³, T⁴ and T⁵ are a single bond.

According to an embodiment wherein T¹, T² and T³ may be independently selected from phenylene and one of T¹, T² and T³ are a single bond. According to an embodiment wherein T¹, T² and T³ may be independently selected from phenylene and two of T¹, T² and T³ are a single bond.

According to an embodiment wherein T⁶ may be phenylene, biphenylene, terphenylene. According to an embodiment wherein T⁶ may be phenylene. According to an embodiment wherein T⁶ may be biphenylene. According to an embodiment wherein T⁶ may be terphenylene.

According to an embodiment wherein Ar¹, Ar², Ar³, Ar⁴ and Ar⁵ may be independently selected from D1 to D16: 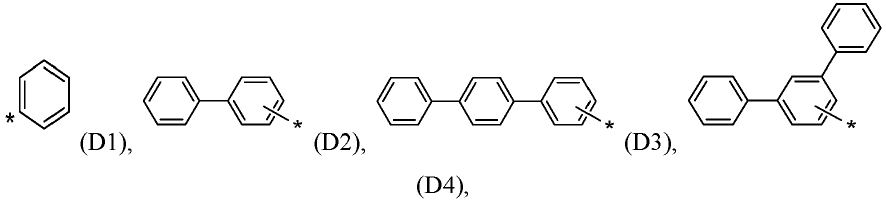 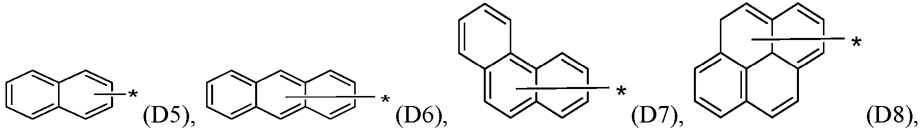 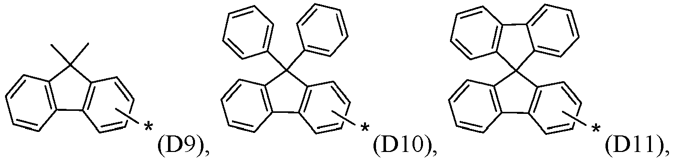 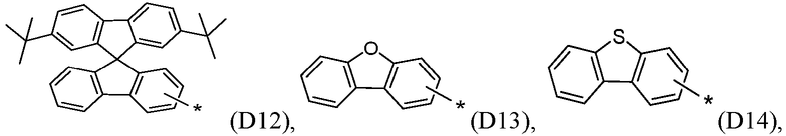 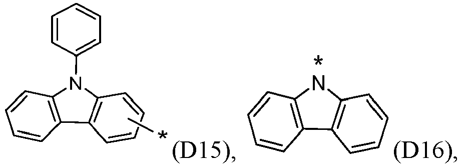 wherein the asterix "*" denotes the binding position.

According to an embodiment, wherein Ar¹, Ar², Ar³, Ar⁴ and Ar⁵ may be independently selected from D1 to D15; alternatively selected from D1 to D10 and D13 to D15.

According to an embodiment, wherein Ar¹, Ar², Ar³, Ar⁴ and Ar⁵ may be independently selected from the group consisting of D1, D2, D5, D7, D9, D10, D13 to D16.

The rate onset temperature may be in a range particularly suited to mass production, when Ar¹, Ar², Ar³, Ar⁴ and Ar⁵ are selected in this range.

The "matrix compound of formula (VI) or formula (VII)" may be also referred to as "hole transport compound".

According to one embodiment, the substantially covalent matrix compound comprises at least one naphthyl group, carbazole group, dibenzofuran group, dibenzothiophene group and/or substituted fluorenyl group, wherein the substituents are independently selected from methyl, phenyl or fluorenyl.

According to an embodiment of the electronic device, wherein the matrix compound of formula (VI) or formula (VII) are selected from F1 to F18:

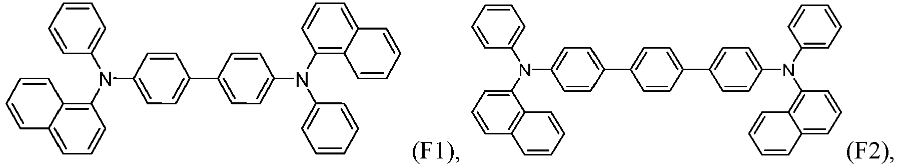

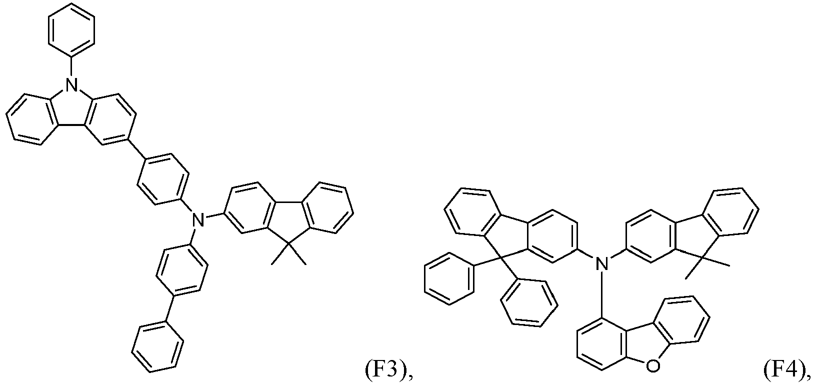

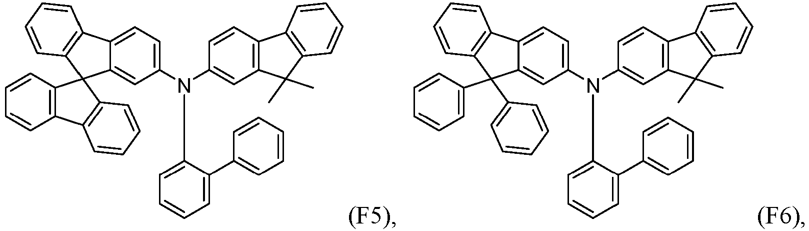

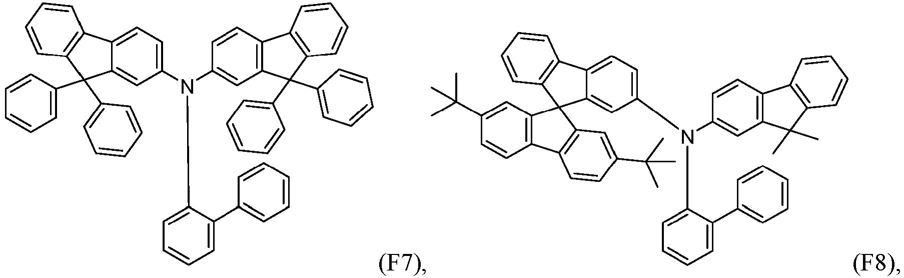

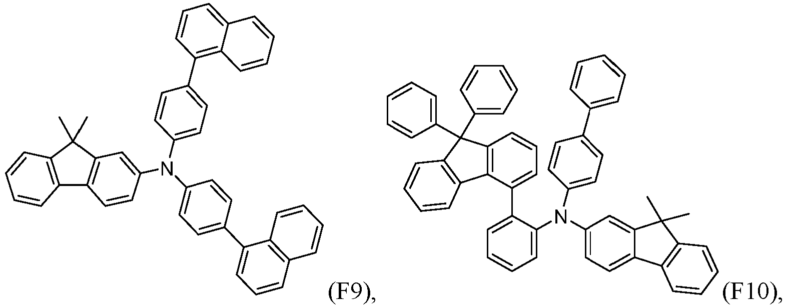

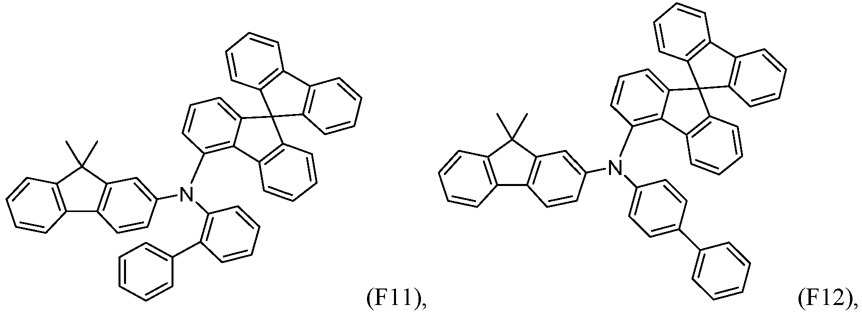

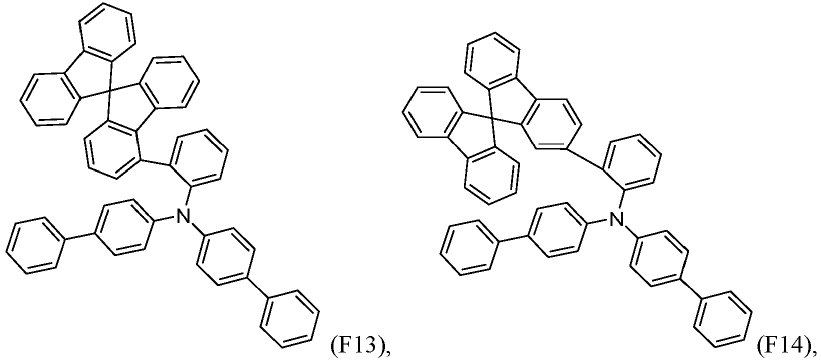

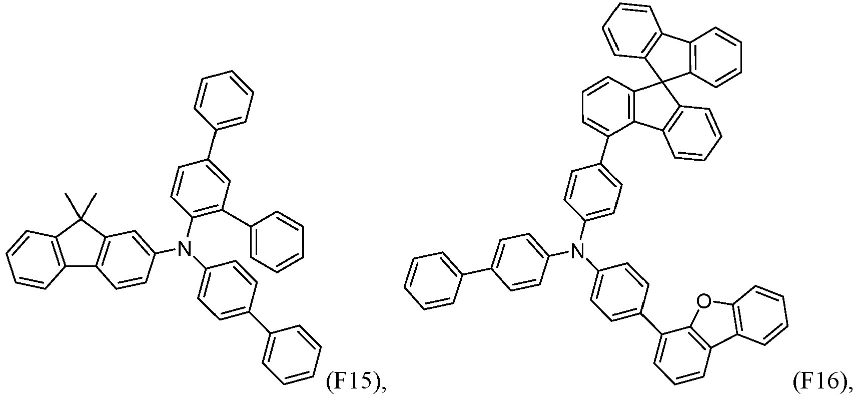

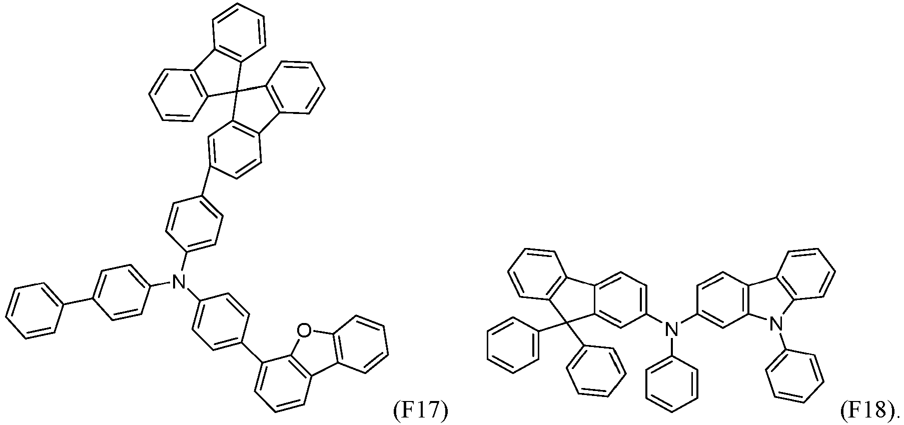

According to one embodiment of the present invention, the photoactive layer is a light emitting layer.

According to one embodiment of the present invention, the organic electronic device is a solar cell or an OLED, preferably an OLED.

According to one embodiment of the present invention, the organic electronic device further comprises a substrate.

According to one embodiment of the present invention, the anode layer comprises a first anode sub-layer and a second anode sub-layer, wherein
- the first anode sub-layer comprises a first metal having a work function in the range of ≥ 4 and ≤ 6 eV, and
- the second anode sub-layer comprises a transparent conductive oxide; and
- the second anode sub-layer is arranged closer to the hole injection layer.

According to one embodiment of the present invention, the first metal of the first anode sub-layer may be selected from the group comprising Ag, Mg, Al, Cr, Pt, Au, Pd, Ni, Nd, Ir, preferably Ag, Au or Al, and more preferred Ag.

According to one embodiment of the present invention, the first anode sub-layer has have a thickness in the range of 5 to 200 nm, alternatively 8 to 180 nm, alternatively 8 to 150 nm, alternatively 100 to 150 nm.

According to one embodiment of the present invention, the first anode sub-layer is formed by depositing the first metal via vacuum thermal evaporation.

It is to be understood that the first anode layer is not part of the substrate.

According to one embodiment of the present invention, the transparent conductive oxide of the second anode sub layer is selected from the group selected from the group comprising indium tin oxide or indium zinc oxide, more preferred indium tin oxide.

According to one embodiment of the present invention, the second anode sub-layer may has a thickness in the range of 3 to 200 nm, alternatively 3 to 180 nm, alternatively 3 to 150 nm, alternatively 3 to 20 nm.

According to one embodiment of the present invention, the second anode sub-layer may be formed by sputtering of the transparent conductive oxide.

According to one embodiment of the present invention, anode layer of the organic electronic device comprises in addition a third anode sub-layer comprising a transparent conductive oxide, wherein the third anode sub-layer is arranged between the substrate and the first anode sub-layer.

According to one embodiment of the present invention, the third anode sub-layer comprises a transparent oxide, preferably from the group selected from the group comprising indium tin oxide or indium zinc oxide, more preferred indium tin oxide.

According to one embodiment of the present invention, the third anode sub-layer may has a thickness in the range of 3 to 200 nm, alternatively 3 to 180 nm, alternatively 3 to 150 nm, alternatively 3 to 20 nm.

According to one embodiment of the present invention, the third anode sub-layer may be formed by sputtering of the transparent conductive oxide.

It is to be understood that the third anode layer is not part of the substrate.

According to one embodiment of the present invention, the hole injection layer is in direct contact with the anode layer.

The present invention furthermore relates to a display device comprising an organic electronic device according to the present invention.

### Further layers

In accordance with the invention, the organic electronic device may comprise, besides the layers already mentioned above, further layers. Exemplary embodiments of respective layers are described in the following:

### Substrate

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

### Hole transport layer

According to one embodiment of the present invention, the organic electronic device comprises a hole transport layer, wherein the hole transport layer is arranged between the hole injection layer and the at least one first emission layer.

The hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

According to one embodiment of the present invention, the hole transport layer may comprise a substantially covalent matrix compound as described above.

According to one embodiment of the present invention, the hole transport layer may comprise a compound of formula (VI) or (VII) as described above.

According to one embodiment of the present invention, the hole injection layer and the hole transport layer comprises the same substantially covalent matrix compound as described above.

According to one embodiment of the present invention, the hole injection layer and the hole transport layer comprises the same compound of formula (VI) or (VII) as described above.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

### Electron blocking layer

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

### Emission layer (EML)

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

According to one embodiment of the present invention, the emission layer does not comprise the compound of formula (I).

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp)3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

### Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and azine derivatives, preferably triazine or pyrimidine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

### Electron transport layer (ETL)

The organic electronic device according to the present invention may further comprise an electron transport layer (ETL).

According to another embodiment of the present invention, the electron transport layer may further comprise an azine compound, preferably a triazine compound.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the EIL is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer comprise an azine compound. Preferably, the azine compound is a triazine compound.

### Electron injection layer (EIL)

An optional EIL, which may facilitates injection of electrons from the cathode, may be formed on the ETL, preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

### Cathode layer

The cathode layer is formed on the ETL or optional EIL. The cathode layer may be formed of a metal, an alloy, an electrically conductive compound, or a mixture thereof. The cathode electrode may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

It is to be understood that the cathode layer is not part of an electron injection layer or the electron transport layer.

### Organic light-emitting diode (OLED)

The organic electronic device according to the invention may be an organic light-emitting device.

According to one aspect of the present invention, there is provided an organic light-emitting diode (OLED) comprising: a substrate; an anode electrode formed on the substrate; a hole injection layer comprising a compound of formula (I), a hole transport layer, an emission layer, an electron transport layer and a cathode electrode.

According to another aspect of the present invention, there is provided an OLED comprising: a substrate; an anode electrode formed on the substrate; a hole injection layer comprising a compound of formula (I), a hole transport layer, an electron blocking layer, an emission layer, a hole blocking layer, an electron transport layer and a cathode electrode.

According to another aspect of the present invention, there is provided an OLED comprising: a substrate; an anode electrode formed on the substrate; a hole injection layer comprising a compound of formula (I), a hole transport layer, an electron blocking layer, an emission layer, a hole blocking layer, an electron transport layer, an electron injection layer, and a cathode electrode.

According to various embodiments of the present invention, there may be provided OLEDs layers arranged between the above mentioned layers, on the substrate or on the top electrode.

According to one aspect, the OLED may comprise a layer structure of a substrate that is adjacent arranged to an anode electrode, the anode electrode is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to a first electron transport layer, the first electron transport layer is adjacent arranged to an n-type charge generation layer, the n-type charge generation layer is adjacent arranged to a hole generating layer, the hole generating layer is adjacent arranged to a second hole transport layer, the second hole transport layer is adjacent arranged to a second electron blocking layer, the second electron blocking layer is adjacent arranged to a second emission layer, between the second emission layer and the cathode electrode an optional electron transport layer and/or an optional injection layer are arranged.

The organic semiconductor layer according to the invention may be the first hole injection layer and/or the p-type charge generation layer.

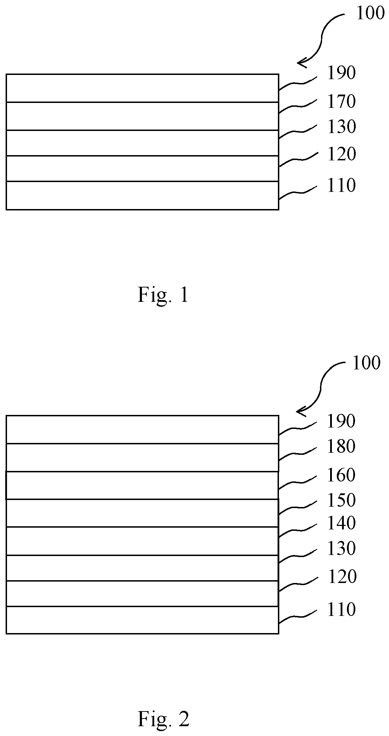

For example, the OLED according to Fig. 2 may be formed by a process, wherein on a substrate (110), an anode (120), a hole injection layer (130) which may comprise compound of formula (I), a hole transport layer (140), an electron blocking layer (145), an emission layer (150), a hole blocking layer (155), an electron transport layer (160), an electron injection layer (180) and the cathode electrode (190) are subsequently formed in that order.

### Organic electronic device

The organic electronic device according to the invention may be a light emitting device, or a photovoltaic cell, and preferably a light emitting device.

According to one embodiment of the present invention, the semiconductor layer and/or metal compound are non-emissive.

In the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about ≥ 380 nm to about ≤ 780 nm.

According to one embodiment of the present invention, the photoactive layer is a light emitting layer.

In the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about ≥ 380 nm to about ≤ 780 nm.

According to one embodiment of the present invention, the organic electronic device comprises at least two or at least three semiconductor layers, wherein the at least two semiconductor layers or the at least three semiconductor layers are arranged between the anode and the at least one photoactive layer.

According to one embodiment of the present invention, the organic electronic device comprises a first semiconductor layer, a second semiconductor layer and a third semiconductor layer, wherein the first, the second and third semiconductor layer are arranged between the anode and the at least one photoactive layer, wherein the first semiconductor layer comprises said compounds, wherein the first semiconductor layer is closer to the anode than the second and third semiconductor layer.

**According** to one embodiment of the present invention, the at least one semiconductor layer comprises a metal compound in an amount in the range of about > 50 wt.-% to about < 100 wt.-%, preferably about > 60 wt.- % to about < 100 wt.-%, further preferred about > 70 wt.-% to about < 100 wt.-%, in addition preferred about > 80 wt.-% to about < 100 wt.-%, or about > 95 wt.-% to about < 100 wt.-%, or about > 98 wt.-% to about < 100 wt.-%, with respect to the total weight of the semiconductor layer, respectively.

According to one embodiment of the present invention, the organic semiconductor layer may comprise:
- at least about ≥ 0.5 wt.-% to about ≤ 30 wt.-%, preferably about ≥ 0.5 wt.-% to about ≤ 20 wt.-%, and more preferred about ≥ 1 wt.-% to about ≤ 15 wt.-% of a metal compound, and
- at least about ≥ 70 wt.-% to about ≤ 99.5 wt.-%, preferably about ≥ 80 wt.-% to about ≤ 99.5 wt.-%, and more preferred about ≥ 85 wt.-% to about ≤ 99 wt.-% of a substantially covalent matrix compound; preferably the wt.-% of the metal compound is lower than the wt.-% of the substantially covalent matrix compound; wherein the weight-% of the components are based on the total weight of the organic semiconductor layer.

According to another aspect of the present invention, there is provided a method of manufacturing an organic electronic device, the method using:
- at least one deposition source, preferably two deposition sources and more preferred at least three deposition sources.

The methods for deposition that can be suitable comprise:
- deposition via vacuum thermal evaporation;
- deposition via solution processing, preferably the processing is selected from spincoating, printing, casting; and/or
- slot-die coating.

According to various embodiments of the present invention, there is provided a method using:
- a first deposition source to release the compound of formula (I) according to the invention, and
- a second deposition source to release the substantially covalent matrix compound;
the method comprising the steps of forming the hole injection layer; whereby for an organic light-emitting diode (OLED):
- the hole injection layer is formed by releasing the compound of formula (I) according to the invention from the first deposition source and the substantially covalent matrix compound from the second deposition source.

According to various embodiments of the present invention, the method may further include forming on the anode electrode, at least one layer selected from the group consisting of forming a hole transport layer or forming a hole blocking layer, and an emission layer between the anode electrode and the first electron transport layer.

According to various embodiments of the present invention, the method may further include the steps for forming an organic light-emitting diode (OLED), wherein
- on a substrate an anode electrode is formed,
- on the anode electrode a hole injection layer comprising a compound of formula (I) is formed,
- on the hole injection layer comprising a compound of formula (I) a hole transport layer is formed,
- on the hole transport layer an emission layer is formed,
- on the emission layer an electron transport layer is formed, optionally a hole blocking layer is formed on the emission layer,
- and finally a cathode electrode is formed,
- optional a hole blocking layer is formed in that order between the first anode electrode and the emission layer,
- optional an electron injection layer is formed between the electron transport layer and the cathode electrode.

According to various embodiments, the OLED may have the following layer structure, wherein the layers having the following order:
anode, hole injection layer comprising a compound of formula (I) according to the invention, first hole transport layer, second hole transport layer, emission layer, optional hole blocking layer, electron transport layer, optional electron injection layer, and cathode.

According to another aspect of the invention, it is provided an electronic device comprising at least one organic light emitting device according to any embodiment described throughout this application, preferably, the electronic device comprises the organic light emitting diode in one of embodiments described throughout this application. More preferably, the electronic device is a display device.

According to another aspect of the invention, it is provided a use of a metal compound in an organic electronic device, the metal compound comprising a metal cation and at least one borate anion of formula (I) 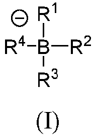
wherein R¹, R², R³, and R⁴ are independently selected from H, electron-withdrawing group, halogen, Cl, F, CN, substituted or unsubstituted C₁ to C₂₄ alkyl, substituted or unsubstituted C₃ to C₂₄ carbocyclyl, substituted or unsubstituted C₂ to C₂₄ heterocyclyl, substituted or unsubstituted C₆ to C₂₄ aryl, or substituted or unsubstituted C₂ to C₂₄ heteroaryl, and two of R¹, R², R³, and R⁴ together can form a ring with the boron atom;
wherein the substituents on R¹, R², R³, and R⁴, if present, are independently selected from electron-withdrawing group, halogen, Cl, F, CN, NO₂, partially fluorinated or perfluorinated alkoxy, partially fluorinated or perfluorinated alkyl, partially fluorinated or perfluorinated aryl, partially fluorinated or perfluorinated heteroaryl, partially fluorinated or perfluorinated carbocyclyl, and partially fluorinated or perfluorinated heterocyclyl;
and wherein at least one R¹, R², R³, and R⁴ is attached to the boron atom via a carbon atom,
wherein the organic electronic device comprises an anode layer, a cathode layer, at least one semiconductor layer, and at least one photoactive layer, wherein the at least one photoactive layer is arranged between the anode layer and the cathode layer, and wherein the at least one semiconductor layer is arranged between the anode layer and the at least one photoactive layer,
wherein the metal compound is used in the at least one semiconductor layer.

Particularly, the use metal compound used can be defined in the same way as the metal compound from the organic optoelectronic device according to the present invention.

According to one embodiment of the present invention, the metal compound is used as a p-dopand or as a hole injection material.

According to another aspect of the invention, it is provided a method for preparation of the organic electronic device according to the present invention, the method comprising at least the following steps:
(a) Providing a surface;
(b) Providing a metal compound, wherein the metal compound comprises a metal cation and at least one borate anion of formula (I)

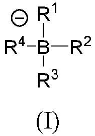

wherein R¹, R², R³, and R⁴ are independently selected from H, electron-withdrawing group, halogen, Cl, F, CN, substituted or unsubstituted C₁ to C₂₄ alkyl, substituted or unsubstituted C₃ to C₂₄ carbocyclyl, substituted or unsubstituted C₂ to C₂₄ heterocyclyl, substituted or unsubstituted C₆ to C₂₄ aryl, or substituted or unsubstituted C₂ to C₂₄ heteroaryl, and two of R¹, R², R³, and R⁴ together can form a ring with the boron atom;
wherein the substituents on R¹, R², R³, and R⁴, if present, are independently selected from electron-withdrawing group, halogen, Cl, F, CN, NO₂, partially fluorinated or perfluorinated alkoxy, partially fluorinated or perfluorinated alkyl, partially fluorinated or perfluorinated aryl, partially fluorinated or perfluorinated heteroaryl, partially fluorinated or perfluorinated carbocyclyl, and partially fluorinated or perfluorinated heterocyclyl;
and wherein at least one R¹, R², R³, and R⁴ is attached to the boron atom via a carbon atom;
   (c) Evaporating the metal compound at a reduced pressure;
   (d) Depositing the evaporated metal compound on the surface.

Particularly, the metal compound used in the method can be defined in the same way as the metal compound from the organic optoelectronic device according to the present invention.

Hereinafter, the embodiments are illustrated in more detail with reference to examples. However, the present disclosure is not limited to the following examples. Reference will now be made in detail to the exemplary aspects.
FIG. 1 is a schematic sectional view of an organic electronic device, according to an exemplary embodiment of the present invention;
FIG. 2 is a schematic sectional view of an organic light-emitting diode (OLED), according to an exemplary embodiment of the present invention;
FIG. 3 is a schematic sectional view of an OLED, according to an exemplary embodiment of the present invention.
FIG. 4 is a schematic sectional view of an OLED, according to an exemplary embodiment of the present invention.
FIG. 5 is a schematic sectional view of an OLED, according to an exemplary embodiment of the present invention.

Hereinafter, the figures are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of an organic electronic device 100, according to an exemplary embodiment of the present invention. The organic electronic device 100 includes a substrate 110, an anode layer 120 and a hole injection layer (HIL) 130 which may comprise a compound of formula (I). The HIL 130 is disposed on the anode layer 120. Onto the HIL 130, a photoactive layer (PAL) 170 and a cathode layer 190 are disposed.

FIG. 2 is a schematic sectional view of an organic light-emitting diode (OLED) 100, according to an exemplary embodiment of the present invention. The OLED 100 includes a substrate 110, an anode layer 120 and a hole injection layer (HIL) 130 which may comprise a compound of formula (I). The HIL 130 is disposed on the anode layer 120. Onto the HIL 130, a hole transport layer (HTL) 140, an emission layer (EML) 150, an electron transport layer (ETL) 160, an electron injection layer (EIL) 180 and a cathode layer 190 are disposed. Instead of a single electron transport layer 160, optionally an electron transport layer stack (ETL) can be used.

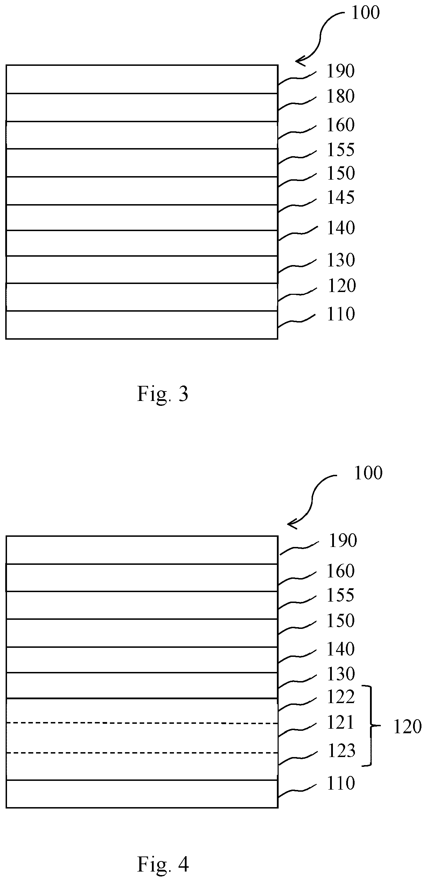

FIG. 3 is a schematic sectional view of an OLED 100, according to another exemplary embodiment of the present invention. Fig. 3 differs from Fig. 2 in that the OLED 100 of Fig. 3 comprises an electron blocking layer (EBL) 145 and a hole blocking layer (HBL) 155.

Referring to Fig. 3, the OLED 100 includes a substrate 110, an anode layer 120, a hole injection layer (HIL) 130 which may comprise a compound of formula (I), a hole transport layer (HTL) 140, an electron blocking layer (EBL) 145, an emission layer (EML) 150, a hole blocking layer (HBL) 155, an electron transport layer (ETL) 160, an electron injection layer (EIL) 180 and a cathode layer 190.

FIG. 4 is a schematic sectional view of an organic electronic device 100, according to an exemplary embodiment of the present invention. The organic electronic device 100 includes a substrate 110, an anode layer 120 that comprises a first anode sub-layer 121, a second anode sub-layer 122 and a third anode sub-layer 123, and a hole injection layer (HIL) 130. The HIL 130 is disposed on the anode layer 120. Onto the HIL 130, an hole transport layer (HTL) 140, a first emission layer (EML) 150, a hole blocking layer (HBL) 155, an electron transport layer (ETL) 160, and a cathode layer 190 are disposed. The hole injection layer 130 may comprise a compound of formula (I).

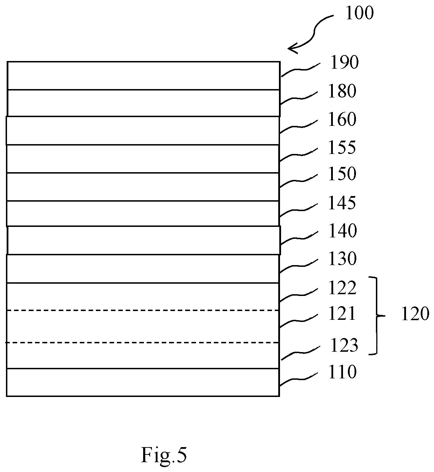

FIG. 5 is a schematic sectional view of an organic electronic device 100, according to an exemplary embodiment of the present invention. The organic electronic device 100 includes a substrate 110, an anode layer 120 that comprises a first anode sub-layer 121, a second anode sub-layer 122 and a third anode sub-layer 123, and a hole injection layer (HIL) 130. The HIL 130 is disposed on the anode layer 120. Onto the HIL 130, a hole transport layer (HTL) 140, an electron blocking layer (EBL) 145, a first emission layer (EML) 150, a hole blocking layer (HBL) 155, an electron transport layer (ETL) 160, an electron injection layer (EIL) 180 and a cathode layer 190 are disposed. The hole injection layer 130 may comprise a compound of formula (I).

While not shown in Fig. 1 to Fig. 5 , a capping and/or sealing layer may further be formed on the cathode layer 190, in order to seal the organic electronic device 100. In addition, various other modifications may be applied thereto.

Hereinafter, one or more exemplary embodiments of the present invention will be described in detail with, reference to the following examples. However, these examples are not intended to limit the purpose and scope of the one or more exemplary embodiments of the present invention.

### Experimental data

### Potassium tetrakis(trifluoromethyl)borate K[B(CF₃)₄]

Performed according to the literature.

E. Bernhardt, G. Henkel, H. Willner, G. Pawelke, H. Bürger, Chem. Eur. J. 2001, 7, 4696-4705; E. Bernhardt, M. Finze, H. Willner, Inorg. Chem. 2011, 50, 10268-10273.

### Cesium tetrakis(trifluoromethyl)borate

### Step 1. Synthesis of [Me₃NH][B(CF₃)₄]

K[B(CF₃)₄] (obtained as described above) (2.037 g, 6.250 mmol, 1.00 eq.) and [Me₃NH]Cl (1.418 g, 14.837 mmol, 2.37 eq.) were separately dissolved in deionized water and then mixed together. A white precipitated was formed ([Me₃NH][B(CF₃)₄]), filtered off and washed with water. Yield 82 % (1.787 g, 5.151 mmol).

### Step 2. Synthesis of Cesium tetrakis(trifluoromethyl)borate.

An aqueous solution of NaOH (0.749 g, 18.726 mmo, 5.20 eq.) was added to [Me3NH][B(CF3)4] (1.249 g, 3.600 mmol, 1.00 eq.). Water and trimethylamine were removed under reduced pressure. Water and CsCl (2.737 g, 16.257 mmol, 4.52 eq.) were added to the residue. The aqueous solution was extracted three times with diethyl ether. The combined organic solution was evaporated to dryness. Diethyl ether was added again to the solid to remove any excess of CsCl by filtration. After evaporation in vacuum a white solid was isolated, which was washed with dichloromethane. Yield 700 mg (1.668 mmol, 46 %).

### General procedure for fabrication of OLEDs

For Examples 1 and 2 and Comparative Example 1, a glass substrate with an anode layer comprising a first anode sub-layer of 120 nm Ag, a second anode sub-layer of 8 nm ITO and a third anode sub-layer of 10 nm ITO was cut to a size of 50 mm x 50 mm x 0.7 mm, ultrasonically washed with water for 60 minutes and then with isopropanol for 20 minutes. The liquid film was removed in a nitrogen stream, followed by plasma treatment to prepare the anode layer. The plasma treatment was performed in an atmosphere comprising 97.6 vol.-% nitrogen and 2.4 vol.-% oxygen.

Then, F3 (as disclosed herein with respect to exemplary matrix compounds) as a substantially covalent matrix compound and a metal compound according to table 1 were codeposited in vacuum on the anode layer, to form a hole injection layer (HIL) having a thickness of 10 nm. The composition of the HIL can be seen in Table 2. Then, the substantially covalent matrix compound (N-([1,1'-biphenyl]-4-yl)-9,9-dimethyl-N-(4-(9-phenyl9H-carbazol-3-yl)phenyl)-9H-fluoren-2-amine was vacuum deposited on the HIL, to form a HTL having a thickness of 128 nm. The formula of the substantially covalent matrix compound in the HTL was identical to the substantially covalent matrix compound used in the HIL.

Then N-(4-dibenzo[b,d]furan-4-yl)phenyl)-N-(4-(9-pheny-9H-fluoren-9-yl)phenyl)-[1,1'biphenyl]-4-amine or N-([1,1'-biphenyl]-4-yl)-9,9-diphenyl-N-(4-(triphenylsilyl)phenyl)-9H-fluoren-2-amine (CAS 1613079-70-1) was vacuum deposited on the HTL, to form an electron blocking layer (EBL) having a thickness of 5 nm.

Then 97 vol.-% H09 (Sun Fine Chemicals, Korea) as EML host and 3 vol.-% BD200 (Sun Fine Chemicals, Korea) as fluorescent blue emitter dopant were deposited on the EBL, to form a blue-emitting first emission layer (EML) with a thickness of 20 nm.

Then a hole blocking layer was formed with a thickness of 5 nm by depositing 2-(3'-(9,9-dimethyl-9H-fluoren-2-yl)-[1,1'-biphenyl]-3-yl)-4,6-diphenyl-1,3,5-triazine on the emission layer EML.

Then the electron transporting layer having a thickness of 31 nm was formed on the hole blocking layer by depositing 50 wt.-% 4'-(4-(4-(4,6-diphenyl-1,3,5-triazin-2-yl)phenyl)naphthalen-1-yl)-[1,1'-biphenyl]-4-carbonitrile and 50 wt.-% of LiQ.

Then the electron injection layer having a thickness of 2 nm was formed on the electron transporting layer by depositing Ytterbium at a rate of 0.01 to 1 Å/s at 10⁻⁷ mbar.

Then Ag:Mg (90:10 vol.-%) was evaporated at a rate of 0.01 to 1 Å/s at 10⁻⁷ mbar to form a cathode layer with a thickness of 100 nm on the electron injection layer.

Then, compound of formula F3 was deposited on the cathode layer to form a capping layer with a thickness of 75 nm.

The OLED stack is protected from ambient conditions by encapsulation of the device with a glass slide. Thereby, a cavity is formed, which includes a getter material for further protection.

To assess the performance of the inventive examples compared to the prior art, the current efficiency is measured at 20°C. The current-voltage characteristic is determined using a Keithley 2635 source measure unit, by sourcing an operating voltage U in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/m² using an Instrument Systems CAS-140CT array spectrometer (calibrated by Deutsche Akkreditierungsstelle (DAkkS)) for each of the voltage values.

Lifetime LT of the device is measured at ambient conditions (20°C) and 30 mA/cm², using a Keithley 2400 sourcemeter, and recorded in hours. The brightness of the device is measured using a calibrated photo diode. The lifetime LT is defined as the time till the brightness of the device is reduced to 97 % of its initial value.

To determine the voltage stability over time U(100h)-(1h), a current density of at 30 mA/cm² was applied to the device. The operating voltage was measured after 1 hour and after 50 hours, followed by calculation of the voltage stability for the time period of 1 hour to 50 hours.

### Technical Effect of the invention

**Table 1: Compounds used in the Examples**

| A1 | A2 | C1 |
|---|---|---|
| | | 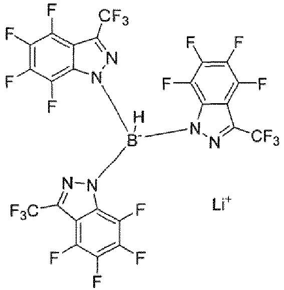 |

**Table 2:**

| **Compoun d** | **Conc. [Vol %]** | **Matrix Compou nd** | **EBL** | **Ceff [cd/ A]** | **LT97, 30 mA/cm 2 [h]** | **V at 15 mA/cm 2 (tbc)** | **V rise At 30mA/c m2 (100-1h) [V]** |
|---|---|---|---|---|---|---|---|
| Comparati ve example (C1) | 3 | F3 | N-(4-dibenzo[b,d]furan-4-yl)phenyl)-N-(4-(9-pheny-9H-fluoren-9-yl)phenyl)-[1,1'biphenyl]-4-amine | 138 | 60 | 3.92 | 0.05 |
| Inventive Example 1 (A1) | 3 | F3 | N-([1,1'-biphenyl]-4-yl)-9,9-diphenyl-N-(4-(triphenylsilyl)phen yl)-9H-fluoren-2-amine (CAS 1613079-70-1) (NHT-211) | 146.5 | 87 | 3.71 | 0.031 |
| Inventive Example 2 (A2) | 3 | F3 | N-(4-dibenzo[b,d]furan-4-yl)phenyl)-N-(4-(9-pheny-9H-fluoren-9-yl)phenyl)-[1,1'biphenyl]-4-amine | 144 | 94 | 3.85 | 0.01 |

A higher Ceff, lower operational voltage, reduction of voltage rise and/or higher life time may be beneficial.

As can be seen from Table 2, the current efficiency (CEff) may be higher and the operating voltage is lower than for the comparative example. A high efficiency and low operating voltage may be beneficial for reduced power consumption and improved battery life, in particular in mobile devices.

As can be seen from Table 2, LT97 at 30 mA/cm2 is higher than for the comparative example. A long lifetime may be beneficial for long-time stability of devices.

As can be seen from Table 2, voltage rise may be lower than for the comparative example.

A reduced increase in operating voltage over time may be an indication for improved stability of the electronic device.

The particular combinations of elements and features in the above detailed embodiments are exemplary only. Accordingly, the foregoing description is by way of example only and is not intended as limiting. In the claims, the word "comprising" does not exclude other elements or steps, and the indefinite article "a" or "an" does not exclude a plurality. The invention's scope is defined in the following claims. Furthermore, reference signs used in the description and claims do not limit the scope of the invention as claimed.

## Claims

1. An organic electronic device comprising an anode layer, a cathode layer, at least one semiconductor layer, and at least one photoactive layer, wherein the at least one photoactive layer is arranged between the anode layer and the cathode layer, and wherein the at least one semiconductor layer is arranged between the anode layer and the at least one photoactive layer,
wherein the at least one semiconductor layer comprises a metal compound comprising a metal cation and at least one borate anion of formula (I) 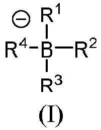
wherein R¹, R², R³, and R⁴ are independently selected from H, electron-withdrawing group, halogen, Cl, F, CN, substituted or unsubstituted C₁ to C₂₄ alkyl, substituted or unsubstituted C₃ to C₂₄ carbocyclyl, substituted or unsubstituted C₂ to C₂₄ heterocyclyl, substituted or unsubstituted C₆ to C₂₄ aryl, or substituted or unsubstituted C₂ to C₂₄ heteroaryl, and two of R¹, R², R³, and R⁴ together can form a ring with the boron atom; wherein the substituents on R¹, R², R³, and R⁴, if present, are independently selected from electron-withdrawing group, halogen, Cl, F, CN, NO₂, partially fluorinated or perfluorinated alkoxy, partially fluorinated or perfluorinated alkyl, partially fluorinated or perfluorinated aryl, partially fluorinated or perfluorinated heteroaryl, partially fluorinated or perfluorinated carbocyclyl, and partially fluorinated or perfluorinated heterocyclyl;
**characterised in that** at least one R¹, R², R³, and R⁴ is attached to the boron atom via a carbon atom.

2. The organic electronic device according to claim 1, wherein at least two of R¹, R², R³, and R⁴ are attached to the boron atom via a carbon atom.

3. The organic electronic device according to any one of claims 1 or 2, wherein the at least one or the at least two of R¹, R², R³, and R⁴ attached to the boron atom via a carbon bond are selected from substituted or unsubstituted C₁ to C₂₄ alkyl, substituted or unsubstituted C₃ to C₂₄ carbocyclyl, substituted or unsubstituted C₂ to C₂₄ heterocyclyl, substituted or unsubstituted C₆ to C₂₄ aryl, or substituted or unsubstituted C₂ to C₂₄ heteroaryl.

4. The organic electronic device according to any one of claims 1 to 3, wherein at least one of R¹, R², R³, and R⁴ are independently selected from Cl, F, CN, substituted or unsubstituted C₁ to C₂₄ alkyl, substituted or unsubstituted C₃ to C₂₄ carbocyclyl, substituted or unsubstituted C₂ to C₂₄ heterocyclyl, substituted or unsubstituted C₆ to C₂₄ aryl, or substituted or unsubstituted C₂ to C₂₄ heteroaryl.

5. The organic electronic device according to any one of claims 1 to 4, wherein for the case that R¹, R², R³, and/or R⁴ is alkyl, carbocyclyl, heterocyclyl, aryl, or heteroaryl, the respective alkyl, carbocyclyl, heterocyclyl, aryl, or heteroaryl is substituted.

6. The organic electronic device according to any one of claims 1 to 5, wherein the substituents on R¹, R², R³, and/or R⁴ are independently selected from Cl, F, CN, NO₂, partially fluorinated or perfluorinated C₁ to C₂₄ alkoxy, partially fluorinated or perfluorinated C₁ to C₂₄ alkyl, partially fluorinated or perfluorinated C₆ to C₂₄ aryl, partially fluorinated or perfluorinated C₂ to C₂₄ heteroaryl, partially fluorinated or perfluorinated C₃ to C₂₄ carbocyclyl, and partially fluorinated or perfluorinated C₂ to C₂₄ heterocyclyl.

7. The organic electronic device according to any one of claims 1 to 6, wherein the substituents on R¹, R², R³, and/or R⁴ are independently selected from F, CF₃, C₂F₅, *n*-C₃F₇, and *iso*-C₃F₇.

8. The organic electronic device according to any one of claims 1 to 7, wherein at least one of R¹, R², R³, and R⁴ are independently selected from F, Cl , CN, CF₃, C₂F₅, *n*-C₃F₇, and *iso*-C₃F₇.

9. The organic electronic device according to any one of claims 1 to 8, wherein at least two of R¹, R², R³, and R⁴ are the same.

10. The organic electronic device according to any one of claims 1 to 9, wherein the metal compound is selected from formula (II): 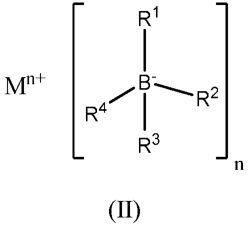 wherein M is a metal cation and n is the valence of the metal cation.

11. The organic electronic device according to claim 10, wherein M is selected from alkali metals, alkaline earth metals, rare earth metals, transition metals, Al, Ga, In, Tl, Sn, Pb, Bi or mixtures thereof and n is 1, 2 or 3.

12. The organic electronic device according to any one of claims 1 to 11, wherein the semiconductor layer is a hole injection layer or hole transport layer.

13. The organic electronic device according to any one of claims 1 to 12, wherein the photoactive layer is a light emitting layer.

14. The organic electronic device according to any one of claims 1 to 13, wherein the organic electronic device is a solar cell or an OLED.

15. A display device comprising an organic electronic device according to any one of the claims 1 to 14.

16. Use of a metal compound in an organic electronic device, the metal compound comprising a metal cation and at least one borate anion of formula (I) 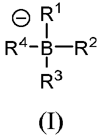
wherein R¹, R², R³, and R⁴ are independently selected from H, electron-withdrawing group, halogen, Cl, F, CN, substituted or unsubstituted C₁ to C₂₄ alkyl, substituted or unsubstituted C₃ to C₂₄ carbocyclyl, substituted or unsubstituted C₂ to C₂₄ heterocyclyl, substituted or unsubstituted C₆ to C₂₄ aryl, or substituted or unsubstituted C₂ to C₂₄ heteroaryl, and two of R¹, R², R³, and R⁴ together can form a ring with the boron atom;
wherein the substituents on R¹, R², R³, and R⁴, if present, are independently selected from electron-withdrawing group, halogen, Cl, F, CN, NO₂, partially fluorinated or perfluorinated alkoxy, partially fluorinated or perfluorinated alkyl, partially fluorinated or perfluorinated aryl, partially fluorinated or perfluorinated heteroaryl, partially fluorinated or perfluorinated carbocyclyl, and partially fluorinated or perfluorinated heterocyclyl;
wherein the organic electronic device comprises an anode layer, a cathode layer, at least one semiconductor layer, and at least one photoactive layer, wherein the at least one photoactive layer is arranged between the anode layer and the cathode layer, and wherein the at least one semiconductor layer is arranged between the anode layer and the at least one photoactive layer,
wherein the metal compound is used in the at least one semiconductor layer, **characterised in that** at least one R¹, R², R³, and R⁴ is attached to the boron atom via a carbon atom.

17. Method for preparation of the organic electronic device according to any one of claims 1 to 14, the method comprising at least the following steps:
(a) Providing a surface;
(b) Providing a metal compound, wherein the metal compound comprises a metal cation and at least one borate anion of formula (I) 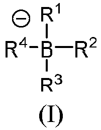
wherein R¹, R², R³, and R⁴ are independently selected from H, electron-withdrawing group, halogen, Cl, F, CN, substituted or unsubstituted C₁ to C₂₄ alkyl, substituted or unsubstituted C₃ to C₂₄ carbocyclyl, substituted or unsubstituted C₂ to C₂₄ heterocyclyl, substituted or unsubstituted C₆ to C₂₄ aryl, or substituted or unsubstituted C₂ to C₂₄ heteroaryl, and two of R¹, R², R³, and R⁴ together can form a ring with the boron atom;
wherein the substituents on R¹, R², R³, and R⁴, if present, are independently selected from electron-withdrawing group, halogen, Cl, F, CN, NO₂, partially fluorinated or perfluorinated alkoxy, partially fluorinated or perfluorinated alkyl, partially fluorinated or perfluorinated aryl, partially fluorinated or perfluorinated heteroaryl, partially fluorinated or perfluorinated carbocyclyl, and partially fluorinated or perfluorinated heterocyclyl;
and wherein at least one R¹, R², R³, and R⁴ is attached to the boron atom via a carbon atom;
(c) Evaporating the metal compound at a reduced pressure;
(d) Depositing the evaporated metal compound on the surface.

## Patentansprüche

1. Organische elektronische Vorrichtung, umfassend eine Anodenschicht, eine Kathodenschicht, mindestens eine Halbleiterschicht und mindestens eine photoaktive Schicht, wobei die mindestens eine photoaktive Schicht zwischen der Anodenschicht und der Kathodenschicht angeordnet ist und wobei die mindestens eine Halbleiterschicht zwischen der Anodenschicht und der mindestens einen photoaktiven Schicht angeordnet ist,
wobei die mindestens eine Halbleiterschicht eine Metallverbindung umfasst, die ein Metallkation und mindestens ein Boratanion der Formel (I) 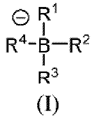
umfasst, wobei R¹, R², R³ und R⁴ unabhängig aus H, einer elektronenziehenden Gruppe, Halogen, Cl, F, CN, substituiertem oder unsubstituiertem C₁- bis C₂₄-Alkyl, substituiertem oder unsubstituiertem C₃- bis C₂₄-Carbocyclyl, substituiertem oder unsubstituiertem C₂- bis C₂₄-Heterocyclyl, substituiertem oder unsubstituiertem C₆- bis C₂₄-Aryl oder substituiertem oder unsubstituiertem C₂-bis C₂₄-Heteroaryl ausgewählt sind und zwei von R¹, R², R³ und R⁴ zusammen mit dem Boratom einen Ring bilden können;
wobei die Substituenten an R¹, R², R³ und R⁴, sofern vorhanden, unabhängig aus einer elektronenziehenden Gruppe, Halogen, Cl, F, CN, NO₂, teilfluoriertem oder perfluoriertem Alkoxy, teilfluoriertem oder perfluoriertem Alkyl, teilfluoriertem oder perfluoriertem Aryl, teilfluoriertem oder perfluoriertem Heteroaryl, teilfluoriertem oder perfluoriertem Carbocyclyl und teilfluoriertem oder perfluoriertem Heterocyclyl ausgewählt sind; **dadurch gekennzeichnet, dass** mindestens eines von R¹, R², R³ und R⁴ über ein Kohlenstoffatom an das Boratom gebunden ist.

2. Organische elektronische Vorrichtung nach Anspruch 1, wobei mindestens zwei von R¹, R², R³ und R⁴ über ein Kohlenstoffatom an das Boratom gebunden sind.

3. Organische elektronische Vorrichtung nach Anspruch 1 oder 2, wobei das mindestens eine von bzw. die mindestens zwei von R¹, R², R³ und R⁴, das bzw. die über eine Kohlenstoffbindung an das Boratom gebunden ist bzw. sind, aus substituiertem oder unsubstituiertem C₁- bis C₂₄-Alkyl, substituiertem oder unsubstituiertem C₃- bis C₂₄-Carbocyclyl, substituiertem oder unsubstituiertem C₂- bis C₂₄-Heterocyclyl, substituiertem oder unsubstituiertem C₆- bis C₂₄-Aryl oder substituiertem oder unsubstituiertem C₂- bis C₂₄-Heteroaryl ausgewählt sind.

4. Organische elektronische Vorrichtung nach einem der Ansprüche 1 bis 3, wobei mindestens eines von R¹, R², R³ und R⁴ unabhängig aus Cl, F, CN, substituiertem oder unsubstituiertem C₁- bis C₂₄-Alkyl, substituiertem oder unsubstituiertem C₃- bis C₂₄-Carbocyclyl, substituiertem oder unsubstituiertem C₂- bis C₂₄-Heterocyclyl, substituiertem oder unsubstituiertem C₆- bis C₂₄-Aryl oder substituiertem oder unsubstituiertem C₂-bis C₂₄-Heteroaryl ausgewählt ist.

5. Organische elektronische Vorrichtung nach einem der Ansprüche 1 bis 4, wobei für den Fall, dass R¹, R², R³ und/oder R⁴ für Alkyl, Carbocyclyl, Heterocyclyl, Aryl oder Heteroaryl steht, das jeweilige Alkyl, Carbocyclyl, Heterocyclyl, Aryl oder Heteroaryl substituiert ist.

6. Organische elektronische Vorrichtung nach einem der Ansprüche 1 bis 5, wobei die Substituenten an R¹, R², R³ und/oder R⁴ unabhängig aus Cl, F, CN, NO₂, teilfluoriertem oder perfluoriertem C₁- bis C₂₄-Alkoxy, teilfluoriertem oder perfluoriertem C₁- bis C₂₄-Alkyl, teilfluoriertem oder perfluoriertem C₆-bis C₂₄-Aryl, teilfluoriertem oder perfluoriertem C₂- bis C₂₄-Heteroaryl, teilfluoriertem oder perfluoriertem C₃- bis C₂₄-Carbocyclyl und teilfluoriertem oder perfluoriertem C₂- bis C₂₄-Heterocyclyl ausgewählt sind.

7. Organische elektronische Vorrichtung nach einem der Ansprüche 1 bis 6, wobei die Substituenten an R¹, R², R³ und/oder R⁴ unabhängig aus F, CF₃, C₂F₅, *n*-C₃F₇ und *iso*-C₃F₇ ausgewählt sind.

8. Organische elektronische Vorrichtung nach einem der Ansprüche 1 bis 7, wobei mindestens eines von R¹, R², R³ und R⁴ unabhängig aus F, Cl, CN, CF₃, C₂F₅, n-C₃F₇ und *iso*-C₃F₇ ausgewählt ist.

9. Organische elektronische Vorrichtung nach einem der Ansprüche 1 bis 8, wobei mindestens zwei von R¹, R², R³ und R⁴ gleich sind.

10. Organische elektronische Vorrichtung nach einem der Ansprüche 1 bis 9, wobei die Metallverbindung aus Formel (II): 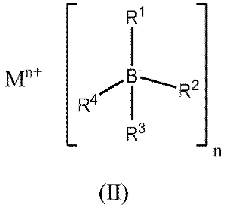 ausgewählt ist, wobei M für ein Metallkation steht und n für die Wertigkeit des Metallkations steht.

11. Organische elektronische Vorrichtung nach Anspruch 10, wobei M aus Alkalimetallen, Erdalkalimetallen, Seltenerdmetallen, Übergangsmetallen, Al, Ga, In, Tl, Sn, Pb, Bi oder Mischungen davon ausgewählt ist und n für 1, 2 oder 3 steht.

12. Organische elektronische Vorrichtung nach einem der Ansprüche 1 bis 11, wobei es sich bei der Halbleiterschicht um eine Lochinjektionsschicht oder eine Lochtransportschicht handelt.

13. Organische elektronische Vorrichtung nach einem der Ansprüche 1 bis 12, wobei es sich bei der photoaktiven Schicht um eine lichtemittierende Schicht handelt.

14. Organische elektronische Vorrichtung nach einem der Ansprüche 1 bis 13, wobei es sich bei der organischen elektronischen Vorrichtung um eine Solarzelle oder eine OLED handelt.

15. Anzeigevorrichtung, umfassend eine organische elektronische Vorrichtung nach einem der Ansprüche 1 bis 14.

16. Verwendung einer Metallverbindung in einer organischen elektronischen Vorrichtung, wobei die Metallverbindung ein Metallkation und mindestens ein Boratanion der Formel (I) 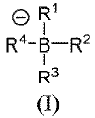
umfasst, wobei R¹, R², R³ und R⁴ unabhängig aus H, einer elektronenziehenden Gruppe, Halogen, Cl, F, CN, substituiertem oder unsubstituiertem C₁- bis C₂₄-Alkyl, substituiertem oder unsubstituiertem C₃- bis C₂₄-Carbocyclyl, substituiertem oder unsubstituiertem C₂- bis C₂₄-Heterocyclyl, substituiertem oder unsubstituiertem C₆- bis C₂₄-Aryl oder substituiertem oder unsubstituiertem C₂-bis C₂₄-Heteroaryl ausgewählt sind und zwei von R¹, R², R³ und R⁴ zusammen mit dem Boratom einen Ring bilden können;
wobei die Substituenten an R¹, R², R³ und R⁴, sofern vorhanden, unabhängig aus einer elektronenziehenden Gruppe, Halogen, Cl, F, CN, NO₂, teilfluoriertem oder perfluoriertem Alkoxy, teilfluoriertem oder perfluoriertem Alkyl, teilfluoriertem oder perfluoriertem Aryl, teilfluoriertem oder perfluoriertem Heteroaryl, teilfluoriertem oder perfluoriertem Carbocyclyl und teilfluoriertem oder perfluoriertem Heterocyclyl ausgewählt sind;
wobei die organische elektronische Vorrichtung eine Anodenschicht, eine Kathodenschicht, mindestens eine Halbleiterschicht und mindestens eine photoaktive Schicht umfasst, wobei die mindestens eine photoaktive Schicht zwischen der Anodenschicht und der Kathodenschicht angeordnet ist und wobei die mindestens eine Halbleiterschicht zwischen der Anodenschicht und der mindestens einen photoaktiven Schicht angeordnet ist,
wobei die Metallverbindungen in der mindestens einen Halbleiterschicht verwendet wird,
**dadurch gekennzeichnet, dass** mindestens eines von R¹, R², R³ und R⁴ über ein Kohlenstoffatom an das Boratom gebunden ist.

17. Verfahren zur Herstellung der organischen elektronischen Vorrichtung nach einem der Ansprüche 1 bis 14, wobei das Verfahren mindestens die folgenden Schritte umfasst:
(a) Bereitstellen einer Oberfläche;
(b) Bereitstellen einer Metallverbindung, wobei die Metallverbindung ein Metallkation und mindestens ein Boratanion der Formel (I) 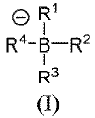
umfasst, wobei R¹, R², R³ und R⁴ unabhängig aus H, einer elektronenziehenden Gruppe, Halogen, Cl, F, CN, substituiertem oder unsubstituiertem C₁- bis C₂₄-Alkyl, substituiertem oder unsubstituiertem C₃- bis C₂₄-Carbocyclyl, substituiertem oder unsubstituiertem C₂- bis C₂₄-Heterocyclyl, substituiertem oder unsubstituiertem C₆- bis C₂₄-Aryl oder substituiertem oder unsubstituiertem C₂- bis C₂₄-Heteroaryl ausgewählt sind und zwei von R¹, R², R³ und R⁴ zusammen mit dem Boratom einen Ring bilden können;
wobei die Substituenten an R¹, R², R³ und R⁴, sofern vorhanden, unabhängig aus einer elektronenziehenden Gruppe, Halogen, Cl, F, CN, NO₂, teilfluoriertem oder perfluoriertem Alkoxy, teilfluoriertem oder perfluoriertem Alkyl, teilfluoriertem oder perfluoriertem Aryl, teilfluoriertem oder perfluoriertem Heteroaryl, teilfluoriertem oder perfluoriertem Carbocyclyl und teilfluoriertem oder perfluoriertem Heterocyclyl ausgewählt sind;
und wobei mindestens eines von R¹, R², R³ und R⁴ über ein Kohlenstoffatom an das Boratom gebunden ist;
(c) Verdampfen der Metallverbindung bei einem verminderten Druck;
(d) Abscheiden der verdampften Metallverbindung auf der Oberfläche.

## Revendications

1. Dispositif électronique organique comprenant une couche d'anode, une couche de cathode, au moins une couche de semi-conducteur, et au moins une couche photoactive, l'au moins une couche photoactive étant agencée entre la couche d'anode et la couche de cathode, et l'au moins une couche de semi-conducteur étant agencée entre la couche d'anode et l'au moins une couche photoactive,
l'au moins une couche de semi-conducteur comprenant un composé métallique comprenant un cation métallique et au moins un anion borate de formule (I) 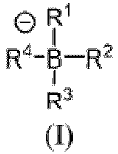
R¹, R², R³ et R⁴ étant indépendamment choisis parmi H, un groupe électroattracteur, un halogène, Cl, F, CN, alkyle en C₁ à C₂₄ substitué ou non substitué, carbocyclyle en C₃ à C₂₄ substitué ou non substitué, hétérocyclyle en C₂ à C₂₄ substitué ou non substitué, aryle en C₆ à C₂₄ substitué ou non substitué, ou hétéroaryle en C₂ à C₂₄ substitué ou non substitué, et deux parmi R¹, R², R³ et R⁴ pouvant former ensemble un cycle avec l'atome de bore ;
les substituants sur R¹, R², R³ et R⁴, s'ils sont présents, étant indépendamment choisis parmi un groupe électroattracteur, un halogène, Cl, F, CN, NO₂, alcoxy partiellement fluoré ou perfluoré, alkyle partiellement fluoré ou perfluoré, aryle partiellement fluoré ou perfluoré, hétéroaryle partiellement fluoré ou perfluoré, carbocyclyle partiellement fluoré ou perfluoré et hétérocyclyle partiellement fluoré ou perfluoré ;
**caractérisé en ce qu'**au moins un R¹, R², R³ et R⁴ est fixé à l'atome de bore par l'intermédiaire d'un atome de carbone.

2. Dispositif électronique organique selon la revendication 1, au moins deux parmi R¹, R², R³ et R⁴ étant fixés à l'atome de bore via un atome de carbone.

3. Dispositif électronique organique selon l'une quelconque des revendications 1 ou 2, l'au moins un ou les au moins deux parmi R¹, R², R³ et R⁴ fixés à l'atome de bore via une liaison carbone étant choisis parmi alkyle en C₁ à C₂₄ substitué ou non substitué, carbocyclyle en C₃ à C₂₄ substitué ou non substitué, hétérocyclyle en C₂ à C₂₄ substitué ou non substitué, aryle en C₆ à C₂₄ substitué ou non substitué, ou hétéroaryle en C₂ à C₂₄ substitué ou non substitué.

4. Dispositif électronique organique selon l'une quelconque des revendications 1 à 3, au moins l'un parmi R¹, R², R³ et R⁴ étant indépendamment choisi parmi Cl, F, CN, alkyle en C₁ à C₂₄ substitué ou non substitué, carbocyclyle en C₃ à C₂₄ substitué ou non substitué, hétérocyclyle en C₂ à C₂₄ substitué ou non substitué, aryle en C₆ à C₂₄ substitué ou non substitué, ou hétéroaryle en C₂ à C₂₄ substitué ou non substitué.

5. Dispositif électronique organique selon l'une quelconque des revendications 1 à 4, dans le cas où R¹, R², R³ et/ou R⁴ est alkyle, carbocyclyle, hétérocyclyle, aryle ou hétéroaryle, l'alkyle, le carbocyclyle, l'hétérocyclyle, l'aryle ou l'hétéroaryle respectif étant substitué.

6. Dispositif électronique organique selon l'une quelconque des revendications 1 à 5, les substituants sur R¹, R², R³ et/ou R⁴ étant indépendamment choisis parmi Cl, F, CN, et NO₂, alcoxy en C₁ à C₂₄ partiellement fluoré ou perfluoré, alkyle en C₁ à C₂₄ partiellement fluoré ou perfluoré, aryle C₆ à C₂₄ partiellement fluoré ou perfluoré ou hétéroaryle C₂ à C₂₄ partiellement fluoré ou perfluoré, carbocyclyle C₃ à C₂₄ partiellement fluoré ou perfluoré, et hétérocyclyle C₂ à C₂₄ partiellement fluoré ou perfluoré.

7. Dispositif électronique organique selon l'une quelconque des revendications 1 à 6, les substituants sur R¹, R², R³ et/ou R⁴ étant indépendamment choisis parmi F, CF₃, C₂F₅, *n*-C₃F₇ et *iso*-C₃F₇*.*

8. Dispositif électronique organique selon l'une quelconque des revendications 1 à 7, au moins l'un parmi R¹, R², R³ et R⁴ étant indépendamment choisis parmi F, Cl, CN, CF₃, C₂F₅, *n*-C₃F₇ et *iso*-C₃F₇.

9. Dispositif électronique organique selon l'une quelconque des revendications 1 à 8, au moins deux parmi R¹, R², R³ et R⁴ étant les mêmes.

10. Dispositif électronique organique selon l'une quelconque des revendications 1 à 9, le composé métallique étant choisi parmi la formule (II) : 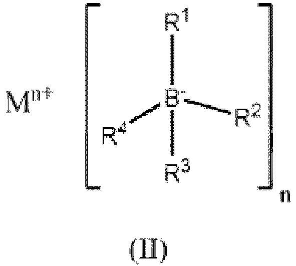 M étant un cation métallique et n étant la valence du cation métallique.

11. Dispositif électronique organique selon la revendication 10, M étant choisi parmi des métaux alcalins, des métaux alcalino-terreux, des métaux des terres rares, des métaux de transition, Al, Ga, In, Tl, Sn, Pb, Bi ou des mélanges correspondants et n étant 1, 2 ou 3.

12. Dispositif électronique organique selon l'une quelconque des revendications 1 à 11, la couche de semi-conducteur étant une couche d'injection de trous ou une couche de transport de trous.

13. Dispositif électronique organique selon l'une quelconque des revendications 1 à 12, la couche photoactive étant une couche émettrice de lumière.

14. Dispositif électronique organique selon l'une quelconque des revendications 1 à 13, le dispositif électronique organique étant une cellule solaire ou une OLED.

15. Dispositif d'affichage comprenant un dispositif électronique organique selon l'une des revendications 1 à 14.

16. Utilisation d'un composé métallique dans un dispositif électronique organique, le composé métallique comprenant un cation métallique et au moins un anion borate de formule (I) 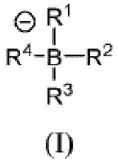
R¹, R², R³ et R⁴ étant indépendamment choisis parmi H, un groupe électroattracteur, un halogène, Cl, F, CN, alkyle en C₁ à C₂₄ substitué ou non substitué, carbocyclyle en C₃ à C₂₄ substitué ou non substitué, hétérocyclyle en C₂ à C₂₄ substitué ou non substitué, aryle en C₆ à C₂₄ substitué ou non substitué, ou hétéroaryle en C₂ à C₂₄ substitué ou non substitué, et deux parmi R¹, R², R³ et R⁴ pouvant former ensemble un cycle avec l'atome de bore ;
les substituants sur R¹, R², R³ et R⁴, s'ils sont présents, étant indépendamment choisis parmi un groupe électroattracteur, un halogène, Cl, F, CN, NO₂, alcoxy partiellement fluoré ou perfluoré, alkyle partiellement fluoré ou perfluoré, aryle partiellement fluoré ou perfluoré, hétéroaryle partiellement fluoré ou perfluoré, carbocyclyle partiellement fluoré ou perfluoré et hétérocyclyle partiellement fluoré ou perfluoré ;
le dispositif électronique organique comprenant une couche d'anode, une couche de cathode, au moins une couche de semi-conducteur, et au moins une couche photoactive, l'au moins une couche photoactive étant agencée entre la couche d'anode et la couche de cathode, et l'au moins une couche de semi-conducteur étant agencée entre la couche d'anode et l'au moins une couche photoactive,
le composé métallique étant utilisé dans l'au moins une couche de semi-conducteur,
**caractérisée en ce qu'**au moins un R¹, R², R³ et R⁴ est fixé à l'atome de bore par l'intermédiaire d'un atome de carbone.

17. Procédé pour la préparation du dispositif électronique organique selon l'une quelconque des revendications 1 à 14, le procédé comprenant au moins les étapes suivantes :
(a) fourniture d'une surface ;
(b) fourniture d'un composé métallique, le composé métallique comprenant un cation métallique et au moins un anion borate de formule (1) 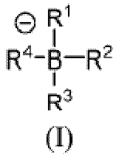
R¹, R², R³ et R⁴ étant indépendamment choisis parmi H, un groupe électroattracteur, un halogène, Cl, F, CN, alkyle en C₁ à C₂₄ substitué ou non substitué, carbocyclyle en C₃ à C₂₄ substitué ou non substitué, hétérocyclyle en C₂ à C₂₄ substitué ou non substitué, aryle en C₆ à C₂₄ substitué ou non substitué, ou hétéroaryle en C₂ à C₂₄ substitué ou non substitué, et deux parmi R¹, R², R³ et R⁴ pouvant former ensemble un cycle avec l'atome de bore ; les substituants sur R¹, R², R³ et R⁴, s'ils sont présents, étant indépendamment choisis parmi un groupe électroattracteur, un halogène, Cl, F, CN, NO₂, alcoxy partiellement fluoré ou perfluoré, alkyle partiellement fluoré ou perfluoré, aryle partiellement fluoré ou perfluoré, hétéroaryle partiellement fluoré ou perfluoré, carbocyclyle partiellement fluoré ou perfluoré et hétérocyclyle partiellement fluoré ou perfluoré ;
et au moins l'un parmi R¹, R², R³ et R⁴ étant fixé à l'atome de bore via un atome de carbone ;
(c) évaporation du composé métallique à une pression réduite ;
(d) dépôt du composé métallique évaporé sur la surface.
